# EUROPÄISCHE PATENTSCHRIFT

(11) **EP 2 756 320 B1**
(45) Veröffentlichungstag und Bekanntmachung des Hinweises auf die Patenterteilung: **04.11.2020**
(21) Anmeldenummer: 12774942.2
(22) Anmeldetag: 17.09.2012
(51) Int. Cl.: G01R 31/12

(54) **VERFAHREN ZUM ERKENNEN EINER ODER MEHRERER GLEICHZEITIG AUFTRETENDER TEILENTLADUNGS-QUELLEN**
METHOD FOR IDENTIFYING ONE OR MORE SIMULTANEOUSLY OCCURRING PARTIAL DISCHARGE SOURCES
PROCÉDÉ D'IDENTIFICATION D'UNE OU PLUSIEURS SOURCES DE DÉCHARGE PARTIELLE APPARAISSANT SIMULTANÉMENT

(30) Priorität: 16.09.2011 DE 102011082866
(43) Veröffentlichungstag der Anmeldung: 23.07.2014
(73) Patentinhaber: Rudolph, Olaf, 76707 Hambrücken (DE)
(72) Erfinder: Rudolph, Olaf, 76707 Hambrücken (DE)
(74) Vertreter: Schmitt-Nilson Schraud Waibel Wohlfrom Patentanwälte Partnerschaft mbB
(86) Internationale Anmeldenummer: PCT/EP2012/068272
(87) Internationale Veröffentlichungsnummer: WO 2013/038017

(56) Entgegenhaltungen:
- EP-A2- 2 275 974
- US-A1- 2009 119 035
- AL-MARZOUQI H: "The density based segmentation algorithm for interpreting partial discharge data", SOLID DIELECTRICS (ICSD), 2010 10TH IEEE INTERNATIONAL CONFERENCE ON, IEEE, PISCATAWAY, NJ, USA, 4. Juli 2010 (2010-07-04), Seiten 1-3, XP031750766, ISBN: 978-1-4244-7945-0
- KRIVDA A ET AL: "Recognition of multiple partial discharge patterns", HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 17-20, XP006501823, ISBN: 978-0-85296-719-5

## Beschreibung

Diese Erfindung bezieht sich auf ein Verfahren zum Erkennen einer oder mehrerer gleichzeitig auftretender Teilentladungs-Quellen aus Teilentladungs-Messsignalen einer mit einer Wechselspannung beaufschlagten elektrischen Vorrichtung

Teilentladungen treten bei mit Wechselspannung beaufschlagten elektrischen Vorrichtungen auf, wenn Schwachstellen in der elektrischen Isolation vorhanden sind. Ein prominentes Beispiel hierfür sind Teilentladungen, die insbesondere bei Regen oder feuchtem Wetter bei Hochspannungsleitungen oder bei den Porzellan-Isolatoren, mit denen diese an den Masten befestigt sind, vorkommen und als Knistern wahrgenommen werden können. In der freien Luft sind solche Teilentladungen unkritisch, treten sie jedoch in gekapselten Geräten auf, droht ein Überschlag und die Zerstörung des Geräts. Dies gilt insbesondere dann, wenn zur Reduzierung des Platzbedarfs die Leitungen und Geräte in mit unter Druck stehendem Isoliergas gefüllten gasisolierten Schaltanlagen eingebaut werden.

In einer gasisolierten Anlage kann eine Teilentladung aufgrund von Faktoren wie etwa Verunreinigungen, die in der gasisolierten Anlage vorhanden sind, interner Defekte, wie etwa Kratzer oder Grate an der Innenseite des Gehäuses oder des inneren Leiters oder einer ungenauen Montage auftreten. Solche Teilentladungen haben einen großen Einfluss auf das Betriebsverhalten der gasisolierten Anlage und können katastrophale Unfälle hervorrufen, wenn sie nicht frühzeitig erkannt werden.

Die Überwachung und Auswertung solcher gasisolierten Anlagen ist daher ein wichtiges Instrument zur vorbeugenden Instandhaltung und Vermeidung von Störfällen.

Externe und interne Sensoren zur Erfassung von Teilentladungen sind bspw. aus der DE 10 2009 034 062 A1 bekannt. Solche Sensoren erfassen Teilentladungssignale, die in einer gasisolierten Anlage auftreten. Teilentladungen können mit solchen Sensoren gemessen werden, allerdings ist die Zuordnung von gemessenen Teilentladungen zu den tatsächlichen Teilentladungs-Quellen bisher nicht oder nicht zufriedenstellend möglich. Mehrere gleichzeitig auftretende Teilentladungs-Quellen können bislang nicht identifiziert werden.

Es besteht ein Bedarf an der zuverlässigen und eindeutigen Erkennung von Teilentladungs-Quellen, insbesondere von mehreren simultan auftretenden Teilentladungs-Quellen, bei mit einer Wechselspannung beaufschlagten elektrischen Vorrichtungen aus gemessenen Teilentladungs-Messsignalen.

Bei "AL-MARZOUQI H: "The density based segmentation algorithm for interpreting partial discharge data", SOLID DIELECTRICS (ICSD), 2010 10TH IEEE INTERNATIONAL CONFERENCE ON, IEEE, PISCATAWAY, NJ, USA, 4. Juli 2010 (2010-07-04), Seiten 1-3, XP031750766, ISBN: 978-1-4244-7945-0" werden aus einer Häufigkeitsmatrix zunächst einzelne Gebiete von Teilentladungs-Impuls-Matrixfeldern bestimmt. Diese werden danach anhand einer zweidimensionalen cross correlation Funktion mit Referenzsegmenten verglichen, und es wird jedem Gebiet jeweils dasjenige Referenzsegment zugeordnet, das diesem am besten entspricht, womit das Verfahren beendet ist.

Bei KRIVDA A ET AL: "Recognition of multiple partial discharge patterns", HIGH VOLTAGE ENGINEERING, 1999. ELEVENTH INTERNATIONAL SYMPOSIUM ON (CONF. PUBL. NO. 467) LONDON, UK 23-27 AUG. 1999, LONDON, UK, IEE, UK, Bd. 5, 23. August 1999 (1999-08-23), Seiten 17-20, XP006501823, ISBN: 978-0-85296-719-5 wird die Verwendung eines Passend-machen von Vorlagen als ein Werkzeug zum Erkennen von mehrfachen Teilentladungsmustern beschrieben.

Aus der US 2009/119035 A1 ist ein Verfahren zum Analysieren von Teilentladungsdaten, die von einem elektrischen Gerät erfasst worden sind, bekannt. Dieses umfasst das Sammeln von Teilentladungs-Daten von einer ersten elektrischen Vorrichtung, die zu einer Gruppe von elektrischen Geräten gehört. Die Gruppe der elektrischen Vorrichtungen ist zumindest teilweise durch zumindest eine Klassifizierung von elektrischen Vorrichtungen definiert. Das Verfahren umfasst auch einen Vergleich von mindestens einem Teil der Teilentladungsdaten, die von der ersten elektrischen Vorrichtung erfasst worden sind, mit zumindest einem Teil der Teilentladungsdaten, die von mindestens einer zweiten elektrischen Vorrichtung erfasst worden sind. Die mindestens eine zweite elektrische Vorrichtung ist aus der Gruppe der elektrischen Vorrichtungen ausgewählt ist, welche die erste elektrische Vorrichtung enthält.

Die EP 2 275 974 A2 beschäftigt sich nicht mit der Erkennung einer oder mehrerer gleichzeitig auftretender Teilentladungs-Quellen aus Teilentladungs-Messsignalen einer mit einer Wechselspannung beaufschlagten elektrischen Vorrichtung. Aus diesem Dokument ist vielmehr ein System und ein Verfahren zum Klassifizieren von verbundenen Gruppen von Vordergrundpixeln in gescannten Dokumentenbildern entsprechend der Art der Markierung bekannt.

Diese Aufgabe wird durch den Gegenstand der unabhängigen Ansprüche gelöst, vorteilhafte Weiterbildungen ergeben sich aus den abhängigen Ansprüchen.

Ein erfindungemäßes Verfahren zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel, ist in Anspruch 1 definiert.

Durch das erfindungsgemäße Verfahren können eine oder mehrere gleichzeitig auftretende Teilentladungsquellen zuverlässig und automatisiert aus Teilentladungs-Messsignalen erkannt und bestimmt werden.

Dieses Verfahren erkennt eindeutig und zuverlässig sowohl isoliert voneinander auftretende Teilentladungsquellen als auch mehrere gleichzeitig auftretende und sich überlagernde Teilentladungsquellen.

Durch das erfindungsgemäße Verfahren ist eine umfassende Ursachenanalyse von auftretenden Teilentladungen möglich. Kritische Teilentladungsquellen können schnell, eindeutig und zuverlässig erkannt und beseitigt werden. In besonders kritischen Fällen können Schäden durch eine sofortige Notabschaltung verhindert werden.

Durch das erfindungsgemäße Verfahren ist ebenfalls eine umfassende Trendanalyse von auftretenden Teilentladungen möglich. Bei einer wiederholten Anwendung des erfindungsgemäßen Verfahrens auf dieselbe, mit einer Wechselspannung beaufschlagte elektrische Vorrichtung kann detektiert werden, wie sich die erkannten Teilentladungsquellen entwickeln, was eine zusätzliche Sicherheit bietet.

Durch die automatisierte Auswertung kann eine solche Erkennung von einen oder mehreren gleichzeitig auftretenden Teilentladungsquellen aus Teilentladungs-Messsignalen einer mit einer Wechselspannung beaufschlagten elektrischen Vorrichtung einfach und zuverlässig erfolgen, ohne dass Experten zu Rate gezogen werden müssen, was Kosten spart
Bei der mit einer Wechselspannung beaufschlagten elektrischen Vorrichtung kann es sich um eine beliebige Vorrichtung handeln, bei der elektrische Teilentladungen auftreten, beispielsweise eine gasisolierte Anlage, einen Hochspannungsgenerator, einen Transformator, eine elektrische Hochspannungsleitung oder ein elektrisches Kabel.

Das erfindungsgemäße Verfahren erlaubt die differenzierte Bewertung einzelner Signalquellen und nicht nur die integrative Bewertung des gesamten Messsignals. Dadurch werden zum einen Einflüsse unvermeidbarer Störsignale unterdrückt, und zum anderen werden typische stochastische Schwankungen in der Bewertung der Amplitude- und Phasenlage einzelner Teilentladungsimpulse ausgeglichen. Darüber hinaus ermöglicht die Separierung der einzelnen Teilentladungsquellen jeweils darauf abgestimmte spezifische Reparaturmaßnahmen oder anderweitig geeignete Gegenmaßnahmen.

Die erfindungsgemäß durchgeführte Formerkennung, wie sie in den abhängigen Ansprüchen noch spezifischer definiert wird, hat die Vorteile, dass sich die dabei betrachtete Kettenlänge auf den Kern beschränkt und das erfindungsgemäße Verfahren auch bei ausgefransten Formen funktioniert, dass das erfindungsgemäße Verfahren einfach um weitere Formen erweiterbar ist, und dass durch das Zusammenführen von Grundformen auch komplexere Formen erkannt werden können.

Die Vorteile, die sich aus der Betrachtung von Kettenlängen, gegenüber statistischen Verfahren, beispielsweise der Berechnung von Mittelwert, Varianz, Schiefe und Wölbung ergeben, sind, dass die Störsignale von den Nutzdaten separiert werden, was zu signifikant besseren Ergebnissen führt, während statistische Verfahren diese mit aufsummieren, und dass durch das Identifizieren von Kettenlängen eine differenzierte Aussage möglich wird, während statistische Verfahren nur integrierte Werte liefern.

Die Vorteile der Betrachtung von Kettenlängen, wie sie in den abhängigen Ansprüchen noch spezifischer definiert ist, gegenüber neuronalen Netzen sind darin zu sehen, dass diese Herangehensweise resistent gegen eine Änderung der Auflösung ist und unabhängig von der Größe der Form funktioniert, dass sie Lage-unabhängig ist und dass keine Trainingsdaten notwendig sind.

Die Vorteile der erfindungsgemäßen Betrachtung von Kettenlängen, wie dies in den abhängigen Ansprüchen noch spezifischer definiert wird, gegenüber hierarchischen Clusterverfahren sind darin zu sehen, dass die Anzahl der Cluster/Formen vorher nicht bekannt sein muss, wie dies beispielsweise beim k-means Ansatz der Fall ist, sowie dass die erfindungsgemäße Herangehensweise Echtzeit-fähig ist, insbesondere auch bei einer großen Anzahl von TIMs, so dass es nicht nur in der nachträglichen Analyse, sondern auch online bei Überwachungssystemen angewendet werden kann.

Die Vorteile des Wahrscheinlichkeits-basierten Regelwerks mit stetigen Funktionen, das erfindungsgemäß angewendet werden kann und in den abhängigen Ansprüchen noch genauer spezifiziert wird, sind darin zu sehen, dass eine Ausgabe einer Liste von Wahrscheinlichkeiten der Zugehörigkeit zu einer bestimmten Form oder Entladung Auskunft über die Sicherheit der Analyse gibt, dass man im Ergebnis eine sehr gute Aussage über die Sicherheit des Analyseergebnisses erhält, da alle Formen bzw. viele Regeln für jedes Gebiet berechnet werden, dass durch die Fokussierung auf Kerngebiete der Formen Abweichungen der Messgenauigkeiten sowie häufig auftretende Phänomene wie das Scattern oder das Jitten des Messsignals kompensiert werden, und dass ein Vergleich der einzelnen Messung mit Erfahrungswerten anderer früherer oder späterer Messungen durch die Identifikation der Gebiete und Gruppen anhand ihrer Parameter auch den Vergleich zweier Messungen erlaubt, wodurch sich in Serienmessungen Gruppen und/oder gebietsspezifische Trends feststellen lassen.

Die Häufigkeits-Matrix, in die gemessene Teilentladungs-Impulse als Teilentladungs-Impuls-Matrixfelder nach erfasster Impuls-Amplitude und nach erfasster Phasenlage eingetragen sind, kann dabei bspw. durch geeignete Hardware oder Software zur Verfügung gestellt werden, ebenso kann diese gemäß dem erfindungsgemäßen Verfahren selbst erzeugt werden.

Die Zuordnung der Teilentladungs-Impuls-Matrixfelder zu wenigstens einem geschlossenen Gebiet von Teilentladungs-Impuls-Matrixfeldern kann bspw. durch geeignete Hardware oder Software bereits vorgenommen worden sein, sodass das erfindungsgemäße Verfahren von einer Häufigkeits-Matrix ausgeht, in der die Teilentladungs-Impuls-Matrixfelder bereits wenigstens einem geschlossenen Gebiet von Teilentladungs-Impuls-Matrixfeldern zugeordnet sind. Ebenso kann eine solche Zuordnung gemäß dem erfindungsgemäßen Verfahren selbst durchgeführt werden, wie dies nachfolgend noch näher erläutert ist.

Gemäß einer ersten Ausführungsform des erfindungsgemäßen Verfahren werden beim Zuordnen der Teilentladungs-Impuls-Matrixfelder in der Häufigkeits-Matrix zu wenigstens einem geschlossenen Gebiet von Teilentladungs-Impuls-Matrixfeldern zunächst für jedes Teilentladungs-Impuls-Matrixfeld die Eigenschaften Länge zusammenhängender Teilentladungs-Impuls-Matrixfelder in horizontaler Richtung, Länge zusammenhängender Teilentladungs-Impuls-Matrixfelder in vertikaler Richtung, Länge zusammenhängender Teilentladungs-Impuls-Matrixfelder in diagonal steigender Richtung und Länge zusammenhängender Teilentladungs-Impuls-Matrixfelder in diagonal fallender Richtung zugeordnet. Dies stellt eine einfache und effektive Berechnung der Ausdehnung der Teilentladungs-Impuls-Matrixfelder in alle Richtungen dar.

Gemäß dem erfindungsgemäßen Verfahren werden die Teilentladungs-Impuls-Matrixfelder in der Häufigkeits-Matrix anhand ihrer Kettenlängen zu wenigstens einem geschlossenen Gebiet von Teilentladungs-Impuls-Matrixfeldern zugeordnet. Dabei wird in einer allgemeinen Definition unter dem Begriff "Kettenlänge" die Länge von in einer beliebigen Richtung geradlinig aneinandergereihten Teilentladungs-Impuls-Matrixfeldern verstanden.

Gemäß dem erfindungsgemäßen Verfahren werden beim Zuordnen der Teilentladungs-Impuls-Matrixfelder in der Häufigkeits-Matrix zu wenigstens einem geschlossenen Gebiet von Teilentladungs-Impuls-Matrixfeldern für jedes Teilentladungs-Impuls-Matrixfeld die Eigenschaft Länge zusammenhängender Teilentladungs-Impuls-Matrixfelder in horizontaler Richtung mit der Eigenschaft Länge zusammenhängender Teilentladungs-Impuls-Matrixfelder in vertikaler Richtung ins Verhältnis gesetzt, um die abgeleitete Eigenschaft Kreuz-Aspekt zu bestimmen, und/oder wobei für jedes Teilentladungs-Impuls-Matrixfeld die Eigenschaft Länge zusammenhängender Teilentladungs-Impuls-Matrixfelder in diagonal steigender Richtung mit der Eigenschaft Länge zusammenhängender Teilentladungs-Impuls-Matrixfelder in diagonal fallender Richtung, um die abgeleitete Eigenschaft Diagonal-Aspekt zu bestimmen. Dies stellt eine einfache und effektive Berechnung von relevanten Flächenerstreckungseigenschaften für jedes Teilentladungs-Impuls-Matrixfelder dar. Bei dieser Ausführungsform ist somit die Länge der jeweils geradlinig in horizontaler Richtung aneinandergereihten Teilentladungs-Impuls-Matrixfelder eine erste Kettenlänge, die Länge der jeweils geradlinig in vertikaler Richtung aneinandergereihten Teilentladungs-Impuls-Matrixfelder ist eine zweite Kettenlänge, die Länge der jeweils geradlinig in diagonal steigender Richtung aneinandergereihten Teilentladungs-Impuls-Matrixfelder ist eine dritte Kettenlänge, und die Länge der jeweils geradlinig in diagonal fallender Richtung aneinandergereihten Teilentladungs-Impuls-Matrixfelder ist eine vierte Kettenlänge.

Gemäß dem erfindungsgemäßen Verfahren werden beim Zuordnen der Teilentladungs-Impuls-Matrixfelder in der Häufigkeits-Matrix zu wenigstens einem geschlossenen Gebiet von Teilentladungs-Impuls-Matrixfeldern die Eigenschaften Kreuz-Aspekt und Diagonal-Aspekt für jeweils nebeneinanderliegende Teilentladungs-Impuls-Matrixfelder herangezogen, um zu entscheiden, ob jeweils nebeneinanderliegende Teilentladungs-Impuls-Matrixfelder zu demselben geschlossenen Gebiet gehören oder nicht. Dies ist ein einfaches, aber, wie sich gezeigt hat, sehr relevantes Kriterium zum Gruppieren von Teilentladungs-Impuls-Matrixfeldern in gleiche oder unterschiedliche Gebiete.

Gemäß einer weiteren Ausführungsform des erfindungsgemäßen Verfahrens wird beim Zuordnen der Teilentladungs-Impuls-Matrixfelder in der Häufigkeits-Matrix zu wenigstens einem geschlossenen Gebiet von Teilentladungs-Impuls-Matrixfeldern für alle Teilentladungs-Impuls-Matrixfelder paarweise die Abweichung eines Teilentladungs-Impuls-Matrixfelds zu den jeweils horizontal, vertikal und diagonal benachbarten Teilentladungs-Impuls-Matrixfeldern bestimmt, wobei für diese Bestimmung der Ähnlichkeit die abgeleiteten Eigenschaften Kreuz-Aspekt und Diagonal-Aspekt herangezogen werden. Dies ist ein einfaches, aber, wie sich gezeigt hat, sehr relevantes Kriterium zum Gruppieren von Teilentladungs-Impuls-Matrixfeldern in gleiche oder unterschiedliche Gebiete.

Gemäß einer weiteren Ausführungsform des erfindungsgemäßen Verfahrens werden beim Zuordnen der Teilentladungs-Impuls-Matrixfelder in der Häufigkeits-Matrix zu wenigstens einem geschlossenen Gebiet von Teilentladungs-Impuls-Matrixfeldern für jedes Teilentladungs-Impuls-Matrixfeld die Kreuzabweichung nach der folgenden Formel: $Abweichung = max \left(Kreuzabweichung, Diagonaabweichung\right)$ bestimmt. Dies stellt eine einfach durchführbare Berechnung dar, die genaue Ergebnisse liefert.

Hierbei kann zuerst zeilenweise, dann spaltenweise vorgegangen werden, beginnend links unten. Andere Durchlaufreihenfolgen sind ebenfalls möglich.

Gemäß einer weiteren Ausführungsform des erfindungsgemäßen Verfahrens wird für jedes Teilentladungs-Impuls-Matrixfeld dasjenige horizontal, vertikal oder diagonal benachbarte Teilentladungs-Impuls-Matrixfeld bestimmt, das die größtmögliche noch erlaubte Abweichung unterhalb einer vorgegebenen kritischen Maximalabweichung aufweist. Dies ist ein einfaches, aber, wie sich gezeigt hat, sehr relevantes Kriterium zum Gruppieren von Teilentladungs-Impuls-Matrixfeldern in gleiche oder unterschiedliche Gebiete.

Bei dieser Bestimmung kann jeweils bei dem diagonal links darunter liegenden, benachbarten Teilentladungs-Impuls-Matrixfeld begonnen und von unten nach oben und spaltenweise nach rechts vorgegangen werden. Andere Durchlaufreihenfolgen sind ebenfalls möglich.

Gemäß einer weiteren Ausführungsform des erfindungsgemäßen Verfahrens erfolgt das Zuordnen der Teilentladungs-Impuls-Matrixfelder in der Häufigkeits-Matrix zu wenigstens einem geschlossenen Gebiet von Teilentladungs-Impuls-Matrixfeldern dadurch, dass nacheinander für jedes Teilentladungs-Impuls-Matrixfeld das Teilentladungs-Impuls-Matrixfeld und das horizontal, vertikal oder diagonal benachbarte Teilentladungs-Impuls-Matrixfeld mit der größtmöglichen erlaubten Abweichung unterhalb einer vorgegebenen kritischen Maximalabweichung betrachtet werden, und dem Teilentladungs-Impuls-Matrixfeld eine neue Gebietsnummer zugeordnet wird, wenn beide Teilentladungs-Impuls-Matrixfelder noch keine Gebietsnummer haben, dem Teilentladungs-Impuls-Matrixfeld die Gebietsnummer des Nachbar-Teilentladungs-Impuls-Matrixfelds zugeordnet wird, wenn die Gebietsnummer des Nachbar-Teilentladungs-Impuls-Matrixfelds größer ist als die Gebietsnummer des Teilentladungs-Impuls-Matrixfelds, und wenn keine der zwei Bedingungen erfüllt ist, die Gebietsnummer des Teilentladungs-Impuls-Matrixfelds beibehalten wird, und mit der Zuordnung für das nächste Teilentladungs-Impuls-Matrixfeld fortgefahren wird. Dies ist eine einfach durchführbare Gebietszuordnung für die Teilentladungs-Impuls-Matrixfeldern in gleiche oder unterschiedliche Gebiete dar.

Gemäß einer weiteren Ausführungsform des erfindungsgemäßen Verfahrens wird diese Zuordnung solange iterativ auf alle Teilentladungs-Impuls-Matrixfelder angewendet, bis sich keine Änderung von Gebietsnummern mehr ergibt.

Gemäß einer weiteren Ausführungsform des erfindungsgemäßen Verfahrens werden beim Zuordnen der Teilentladungs-Impuls-Matrixfelder in der Häufigkeitsmatrix zu wenigstens einem geschlossenen Gebiet von Teilentladungs-Impuls-Matrixfeldern diejenigen Matrixfelder, die keine Teilentladungs-Impuls-Matrixfelder sind, nicht betrachtet.

Gemäß einer weiteren Ausführungsform des erfindungsgemäßen Verfahrens wird die Zuordnung für ein Teilentladungs-Impuls-Matrixfeld nur dann vorgenommen, wenn die Abweichung für das jeweils betrachtete Teilentladungs-Impuls-Matrixfeld kleiner ist als ein vorgegebener Maximalabweichungswert, der in einem Bereich von 0,6 bis 0,8 liegt und vorzugsweise etwa 0,7 ist, und ansonsten wird mit der Zuordnung für das nächste Teilentladungs-Impuls-Matrixfeld fortgefahren.

Gemäß einer weiteren Ausführungsform des erfindungsgemäßen Verfahrens werden beim Zuordnen der Teilentladungs-Impuls-Matrixfelder in der Häufigkeits-Matrix zu wenigstens einem geschlossenen Gebiet von Teilentladungs-Impuls-Matrixfeldern alle Teilentladungs-Impuls-Matrixfelder entfernt, deren Gebiet zu klein ist, wobei ein Gebiet insbesondere dann zu klein ist, wenn es in Abhängigkeit der Auflösung der Ausgangs-Teilentladungsmatrix beispielsweise weniger als 10 Teilentladungs-Impuls-Matrixfelder umfasst und/oder wenn dessen horizontale oder vertikale Ausdehnung kleiner ist als 8 Teilentladungs-Impuls-Matrixfelder. Dadurch wird entsprechend der Auflösung/Größe der Ausgangs-Teilentladungsmatrix die nachfolgende Berechnung vereinfacht und auf die Gebiete von relevanter Größe konzentriert.

Gemäß einer weiteren Ausführungsform des erfindungsgemäßen Verfahrens handelt es sich bei den Grundformen um wenigstens eine der Grundformen aus der folgenden Gruppe: Punkt; Hügel; Flamme; Turm; Sichel; Flosse; Ebene.

Gemäß einer weiteren Ausführungsform des erfindungsgemäßen Verfahrens wird bei dem Schritt des Vergleichens, für jedes geschlossene Gebiet von Teilentladungs-Impuls-Matrixfeldern, der Gebietsparameter des geschlossenen Gebiets von Teilentladungs-Impuls-Matrixfeldern mit vorgegebenen Regelsätzen, jedem geschlossenen Gebiet ein Wahrscheinlichkeitswert zugeordnet, der der Wahrscheinlichkeit der Übereinstimmung des geschlossenen Gebiets mit der Grundform eines charakteristischen Teilentladungs-Quellensignals entspricht. Durch das Zuordnen von Wahrscheinlichkeitswerten zu den geschlossenen Gebieten kann eine qualifizierte Aussage erfolgen, ob und wie sehr ein geschlossenes Gebiet einer bestimmten Grundform ähnelt.

Gemäß einer weiteren Ausführungsform des erfindungsgemäßen Verfahrens wird die Wahrscheinlichkeit der Übereinstimmung von IST- mit dem SOLL-Wert durch eine stetige Funktion berechnet wird.

Dabei kann als stetige Funktion wenigstens eine der Funktionen $F 1 : = {e}^{- ln \left(ToleranzWert\right) {\left(\frac{IstWert - SollWert}{ToleranzBreite}\right)}^{2}}$ $F 2 : = 0.5 + arctan \left(Normierung∗\left(Verschiebung-IstWert\right)\right)$ $F 3 : = 0.5 - arctan \left(Normierung∗\left(Verschiebung+IstWert\right)\right)$ verwendet werden.

Gemäß einer weiteren Ausführungsform des erfindungsgemäßen Verfahrens wird bei dem Schritt des Zuordnens dem geschlossenen Gebiet derjenige Regelsatz zugeordnet wird, der den höchsten Wahrscheinlichkeitswert der Übereinstimmung aufweist.

Gemäß einer weiteren Ausführungsform des erfindungsgemäßen Verfahrens handelt es sich bei den Fehlerregeln um wenigstens eine Fehlerregel aus der folgenden Gruppe: Fehlerregel für einen Testset, Fehlerregel für eine Ablösung, Fehlerregel für einen Lunker, Fehlerregel für eine Gleitentladung, Fehlerregel für einen Partikel, Fehlerregel für eine Spitze, Fehlerregel für ein freies Potential, Fehlerregel für einen Riß, Fehlerregel für ein Mobiltelefon, Fehlerregel für ein Radarsignal, Fehlerregel für ein Verstärkerrauschen, Fehlerregel für ein zu großes Eingangssignal, Fehlerregel für ein Thyristor-Signal.

Gemäß einer weiteren Ausführungsform des erfindungsgemäßen Verfahrens ordnen die Fehlerregeln bei bestimmten Phasenlagen auftretende Teilentladungs-Impuls-Gebiets-Grundformen bekannten Teilentladungsquellen und bei bestimmten Phasenlagen auftretende zueinander um eine bestimmte Phasenverschiebung beabstandete Grundformen bekannten, ursächlichen Teilentladungsquellen zu. In solchen Fehlerregeln sind aus physikalischen Modellen hergeleitete und/oder empirisch gewonnene Erkenntnisse über bestimmte, sich für ein und dieselbe Teilentladungsquelle wiederholende Fehlercharakteristiken zusammengefasst.

Gemäß einer weiteren Ausführungsform des erfindungsgemäßen Verfahrens werden die Teilentladungs-Messsignale der mit einer Wechselspannung beaufschlagten elektrischen Vorrichtung mit einem Teilentladungs-Sensor / Teilentladungs-Messgerät erfasst.

Die Erfindung betrifft auch ein Teilentladungs-Messgerät, das zur Erfassung von Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel ausgebildet ist, und das dazu eingerichtet ist, ein Verfahren zum Erkennen einer oder mehrerer gleichzeitig auftretender Teilentladungsquellen der oben beschriebenen Art basierend auf den erfassten Teilentladungs-Messsignalen auszuführen. Mit einem solchen Teilentladungs-Messgerät können die Teilentladungs-Messsignale gleich vor Ort schnell und zuverlässig analysiert und automatisch und eindeutig den relevanten Teilentladungsquellen zugeordnet werden.

Die Erfindung betrifft des Weiteren ein Computerprogramm mit Programminstruktionen zur Ausführung eines Verfahrens zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel, das so ausgebildet ist, dass ein Verfahren der oben beschriebenen Art basierend auf erfassten Teilentladungs-Messsignalen durchführbar ist. Mit einem solchen Computerprogramm können erfasste Teilentladungs-Messsignale schnell und zuverlässig analysiert und automatisch und eindeutig den relevanten Teilentladungsquellen zugeordnet werden.

Die Erfindung betrifft ferner ein Computersystem oder Datenträger mit einem Computerprogramm zur Ausführung eines Verfahrens zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel der oben beschriebenen Art.

Das erfindungsgemäße Verfahren zum Erkennen einer oder mehrerer gleichzeitig auftretender Teilentladungs-Quellen aus Teilentladungs-Messsignalen einer mit einer Wechselspannung beaufschlagten elektrischen Vorrichtung ist nachfolgend anhand eines Ausführungsbeispiels mit Bezug auf die beiliegenden Figuren näher erläutert.
- Figur 1a: zeigt eine schematische Darstellung eines Auszugs einer Teilentladungsmessung;
- Figur 1b: zeigt eine aus der Teilentladungsmessung gemäß Figur 1a resultierende Teilentladungsmatrix;
- Figur 2: zeigt eine schematische Darstellung einer kompletten Ausgangs-Teilentladungsmatrix;
- Figur 3: zeigt eine Teilentladungsmatrix, die einen Ausschnitt der kompletten Ausgangs-Teilentladungsmatrix aus Figur 2 darstellt;
- Figur 4a: zeigt die Teilentladungsmatrix aus Figur 3, deren Teilentladungs-Impuls-Matrixfelder mit dem Eigenschaftswert der horizontalen Kettenlänge beschriftet sind;
- Figur 4b: zeigt die Teilentladungsmatrix aus Figur 3, deren Teilentladungs-Impuls-Matrixfelder mit dem Eigenschaftswert der vertikalen Kettenlänge beschriftet sind;
- Figur 5a: zeigt die Teilentladungsmatrix aus Figur 3, deren Teilentladungs-Impuls-Matrixfelder mit dem Eigenschaftswert der diagonal steigenden Kettenlänge beschriftet sind;
- Figur 5b: zeigt die Teilentladungsmatrix aus Figur 3, deren Teilentladungs-Impuls-Matrixfelder mit dem Eigenschaftswert der diagonal fallenden Kettenlänge beschriftet sind;
- Figur 6: zeigt die Teilentladungsmatrix aus Figur 3, deren Teilentladungs-Impuls-Matrixfelder mit dem abgeleiteten Eigenschaftswert des Kreuzaspekts beschriftet sind;
- Figur 7: zeigt die Teilentladungsmatrix aus Figur 3, deren Teilentladungs-Impuls-Matrixfelder mit dem abgeleiteten Eigenschaftswert des Diagonalaspekts beschriftet sind;
- Figur 8: zeigt eine schematische Darstellung eine Abfrage-Reihenfolge für jedes Teilentladungs-Impuls-Matrixfeld;
- Figur 9: zeigt ein Struktogramm eines iterativen Gebietszuordnungsverfahrens für alle Teilentladungs-Impuls-Matrixfelder der Teilentladungsmatrix 6 bzw. 8;
- Figur 10a: zeigt eine 4x6-Teilmatrix Diagonalaspekt der Teilentladungsmatrix aus Figur 7, deren Teilentladungs-Impuls-Matrixfelder mit dem abgeleiteten Eigenschaftswert des Diagonalaspekts beschriftet sind;
- Figur 10b: zeigt eine 4x6-Teilmatrix Kreuzaspekt der Teilentladungsmatrix aus Figur 6, deren Teilentladungs-Impuls-Matrixfelder mit dem abgeleiteten Eigenschaftswert des Kreuzaspekts beschriftet sind;
- Figur 11a: zeigt eine Berechnungsmatrix Diagonalabweichung des Teilentladungs-Impuls-Matrixfelds in Zeile 2, Spalte 2 zu den benachbarten Teilentladungs-Impuls-Matrixfeldern;
- Figur 11b: zeigt eine Berechnungsmatrix Kreuzabweichung des Teilentladungs-Impuls-Matrixfelds in Zeile 2, Spalte 2 zu den benachbarten Teilentladungs-Impuls-Matrixfeldern;
- Figur 12: zeigt eine Berechnungsmatrix Abweichung des Teilentladungs-Impuls-Matrixfelds in Zeile 2, Spalte 2 zu den benachbarten Teilentladungs-Impuls-Matrixfeldern;
- Figur 13a: zeigt eine Teilmatrix Gebietsnummer am Anfang der Teilentladungsmatrix aus Figur 3, deren Teilentladungs-Impuls-Matrixfelder mit ihrer Gebietsnummer am Anfang des iterativen Gebiets-Zuordnungsverfahrens gemäß Figur 9 beschriftet sind;
- Figur 13b: zeigt eine Teilmatrix nach Gebietszuordnung für erstes Teilentladungs-Impuls-Matrixfeld der Teilentladungsmatrix aus Figur 3, deren Teilentladungs-Impuls-Matrixfelder mit ihrer Gebietsnummer nach einem Teildurchlauf des iterativen Gebiets-Zuordnungsverfahrens gemäß Figur 9 beschriftet sind;
- Fig. 14: zeigt die Teilentladungsmatrix aus Figur 3, wobei den TIMs durch einen vollständigen Durchlaufs des iterativen Gebietszuordnungsverfahrens, wie es mit Bezug auf die Figuren 9 bis 13b beschrieben worden ist, Gebiete zugeordnet worden sind;
- Fig. 15a: zeigt die Teilentladungsmatrix aus Figur 3 nach Gebietszuordnung der Teilentladungs-Impuls-Matrixfelder und nach Entfernen der zu kleinen, als geringfügig betrachteten Gebiete von Teilentladungs-Impuls-Matrixfeldern;
- Figur 15b: zeigt die komplette Ausgangs-Teilentladungsmatrix aus Figur 2, deren Teilentladungs-Impuls-Matrixfelder verschiedenen Gebieten zugeordnet worden sind und wobei die zu kleinen, als geringfügig betrachteten Gebiete von Teilentladungs-Impuls-Matrixfeldern entfernt worden sind;
- Figur 16a: zeigt eine schematische Darstellung der Grundform Punkt;
- Figur 16b: zeigt eine schematische Darstellung der Grundform Hügel;
- Figur 16c: zeigt eine schematische Darstellung der Grundform Flamme;
- Figur 16d: zeigt eine schematische Darstellung der Grundform Turm;
- Figur 16e: zeigt eine schematische Darstellung der Grundform Sichel;
- Figur 16f: zeigt eine schematische Darstellung der Grundform Flosse;
- Figur 16g: zeigt eine schematische Darstellung der Grundform Ebene;
- Figur 17a: zeigt eine beispielhafte Berechnungsmatrix zur Berechnung der Krümmung oben und rechts einer Hüllkurve;
- Figur 17b: zeigt eine beispielhafte Berechnungsmatrix zur Berechnung der Krümmung unten und links einer Hüllkurve;
- Figur 18: zeigt eine Berechnungsmatrix zur Berechnung der freien Ecken eines Umhüllungsvierecks;
- Figur 19: zeigt eine Berechnungsmatrix zur Berechnung von freien Seitenmitten eines Umhüllungsrechtecks;
- Figur 20: zeigt eine Berechnungsmatrix zur Berechnung der horizontalen und vertikalen Symmetrie;
- Figur 21: zeigt die Teilentladungsmatrix mit Gebietszuordnung aus Figur 15a, in der die ermittelten und nachfolgend untersuchten Gebiete gesondert eingezeichnet sind;
- Figur 22: zeigt eine Tabelle in der für die drei untersuchten Gebiete die Istwerte für die Gebietsparameter eingetragen sind;
- Figur 23: zeigt eine Formenzuordnungs-Tabelle für die untersuchten Gebiete;
- Figur 24a: zeigt eine Tabelle zur Bestimmung des Wahrscheinlichkeitswerts der Übereinstimmung des Gebiets 1 mit dem Regelsatz Sichel;
- Figur 24b: zeigt eine Tabelle zur Berechnung des Wahrscheinlichkeitswerts der Übereinstimmung des Gebiets 1 mit dem Regelsatz Flosse, und
- Figur 24c: zeigt eine Tabelle zur Berechnung des Wahrscheinlichkeitswerts der Übereinstimmung des Gebiets 1 mit dem Regelsatz Turm.
- Figur 25: zeigt die komplette Ausgangs-Teilentladungsmatrix aus Figur 15b, deren Gebieten Formen zugeordnet worden sind; und
- Figur 26: zeigt die komplette Ausgangs-Teilentladungsmatrix aus Figur 15b, deren ermittelten Gebieten die jeweils ursächlichen Teilentladungs-Quellen zugeordnet worden sind.

In dem hier beschriebenen Ausführungsbeispiel werden zunächst mittels eines Teilentladungssensors oder Teilentladungs-Messgeräts Teilentladungssignale einer mit einer Wechselspannung beaufschlagten elektrischen Vorrichtung erfasst und die dabei erfassten Teilentladungs-Impulse werden in eine so genannte Φqn-Teilentladungsmatrix abgebildet.

Bei der mit einer Wechselspannung beaufschlagten elektrischen Vorrichtung kann es sich um eine beliebige Vorrichtung handeln, bei der elektrische Teilentladungen auftreten, beispielsweise eine gasisolierte Anlage, einen Hochspannungsgenerator, einen Transformator, eine elektrische Hochspannungsleitung oder ein elektrisches Kabel. Im vorliegenden Ausführungsbeispiel ist mit dem Teilentladungs-Messgerät eine gasisolierte Anlage gemessen worden.

Die Messdauer ist üblicherweise festgelegt und beträgt beispielsweise 60 Sekunden.

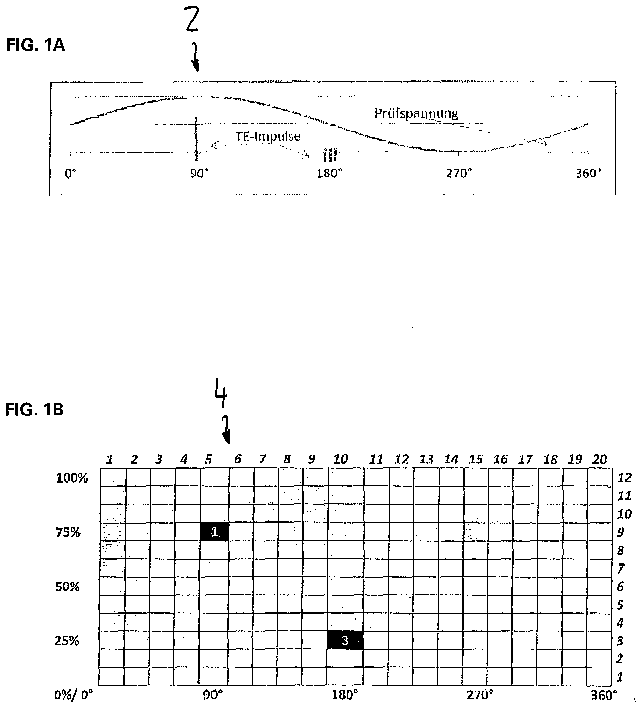

Figur 1a zeigt eine schematische Darstellung eines Auszugs einer Teilentladungsmessung 2;

Bei der Darstellung in Fig. 1a und den folgenden Figuren ist beispielhaft eine Messdauer einer Sinusschwingung dargestellt, welche die an der gasisolierten Schaltanlage anliegende und vom Messgerät erfasste Wechselspannung darstellt. Die Messdauer gemäß Fig. 1a entspricht nur einem Teilbereich der gesamten von einem Teilentladungs-Messgerät typischerweise aufgezeichneten Messdauer.

In Fig. 1a ist diese Sinusschwingung der Wechselspannung der gasisolierten Schaltanlage mittels einer Sinuskurve von 0 bis 360° dargestellt, wobei das Maximum bei 90°, der Nulldurchgang bei 180°, und das Minimum bei 270° liegen.

Die vom Teilentladungs-Messgerät erfassten Teilentladungs-Impulse sind in Fig. 1a mittels vertikalen Balken dargestellt. Wie in Fig, 1a gut zu sehen ist, sind durch das Teilentladungs-Messgerät ein Teilentladungs-Impuls bei einer Phasenlage von 90° und drei Teilentladungs-Impulse bei einer Phasenlage von 180° erfasst worden. Die Höhe der vertikalen Balken entspricht dabei der Impulsamplitude.

Figur 1b zeigt eine aus der Teilentladungsmessung gemäß Figur 1a resultierende Teilentladungsmatrix 4.

Gemäß Fig. 1b werden diese Teilentladungs-Impulse in die Teilentladungsmatrix 4 abgebildet, wobei zur Darstellung der Teilentladungs-Impulse in der Teilentladungsmatrix eine Sortierung erfolgt. Bei der Sortierung gemäß Fig. 1b sind die erfassten Teilentladungs-Impulse gemäß Fig. 1a so sortiert in die Teilentladungsmatrix 4 eingetragen worden, dass auf der Abszisse die relative Phasenlage der anliegenden Prüfwechselspannung und auf der Ordinate die erfasste Impuls-Amplitude eingetragen sind.

In der Teilentladungsmatrix 4 wird das Matrixfeld, dessen X-Wert der relativen Phasenlage von 90° und dessen Y-Wert einer Stärke von 75% entsprechen, als Teilentladungs-Impuls-Matrixfeld gesetzt, und mit der Anzahl der erfassten Teilentladungs-Impulse bei dieser Phasenlage und dieser Impulsamplitude versehen, also mit dem Wert 1.

Dementsprechend wird das Matrixfeld mit X-Wert von 180° und mit Y-Wert von 25% als Teilentladungs-Impuls-Matrixfeld gesetzt und mit dem Wert versehen, welcher der Anzahl der Impulse bei dieser Phasenlage und dieser Impulsamplitude entspricht, im vorliegenden Beispiel also mit dem Wert 3.

Im weiteren Verlauf spielt die Anzahl der Teilentladungs-Impulse pro Teilentladungs-Impuls-Matrixfeld keine Rolle, jedes Teilentladungs-Impuls-Matrixfeld wird lediglich digital betrachtet, so dass, wenn bei diesem Teilentladungs-Impuls-Matrixfeld kein Teilentladungs-Impuls erfasst worden ist, dieses Matrixfeld auch nicht als Teilentladungs-Impuls-Matrixfeld gesetzt wird, und wobei, wenn mindestens ein Teilentladungs-Impuls erfasst worden ist, das entsprechende Matrixfeld als Teilentladungs-Impuls-Matrixfeld gesetzt und mit dem Wert 1 versehen wird, unabhängig davon wie viele Teilentladungs-Impulse bei dieser Phasenlage und der entsprechenden Impuls-Amplitude tatsächlich aufgetreten sind.

Das Ausführungsbeispiel der Fig. 1a und 1b dient lediglich zur Erläuterung der Entstehung einer Teilentladungsmatrix aus einer Teilentladungs-Messung.

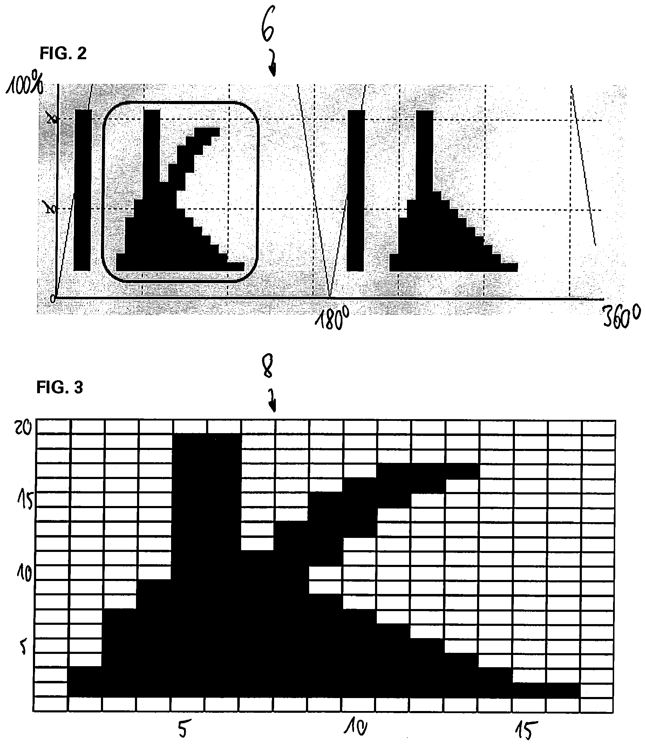

Figur 2 zeigt eine schematische Darstellung einer kompletten Ausgangs-Teilentladungsmatrix 6.

Das Ausführungsbeispiel für das erfindungsgemäße Verfahren zum Erkennen einer oder mehrerer gleichzeitig auftretender Teilentladungsquellen aus Teilentladungs-Messsignalen einer mit einer Wechselspannung beaufschlagten elektrischen Vorrichtung wird nun anhand der folgenden Figuren erläutert, basierend auf einer exemplarischen kompletten Ausgangs-Teilentladungsmatrix 6, wie sie in Fig. 2 dargestellt ist. Diese kompletten Ausgangs-Teilentladungsmatrix 6 ist aus einer Teilentladungs-Messung erstellt worden, wobei - wie mit Bezug auf die Figuren 1a und 1b erläutert - diejenigen Matrixfelder als Teilentladungs-Impuls-Matrixfelder gesetzt worden ist, bei deren Phasenlage und deren Impulsamplitude jeweils mindestens ein Teilentladungs-Impuls aufgetreten ist.

In der kompletten Ausgangs-Teilentladungsmatrix 6 sind die als Teilentladungs-Impuls-Matrixfelder gesetzte Matrixfelder schwarz hinterlegt.

Bei einer Phasenlage von etwa 20° und etwa 200° ist jeweils ein vertikaler Balken zu erkennen, der einer Anzahl von bei dieser Phasenlage erfassten Teilentladungs-Impulsen mit einer Stärke von etwa 20% bis 80% entspricht.

Zwischen einer Phasenlage von etwa 40° bis etwa 130° ist eine Anzahl von Teilentladungs-Impuls-Matrixfeldern zu erkennen, deren Form, von unten nach oben, ein unteres Dreieck, einen von dessen oberer Spitze ausgehenden, sich vertikal nach oben ersteckenden Balken und einen von dessen oberer Spitze ausgehenden, sich schräg nach rechts oben erstreckenden Balken aufweist. Diese Menge von Teilentladungs-Impuls-Matrixfeldern ist in Fig. 2 umkreist dargestellt und wird in den nun folgenden Figuren exemplarisch betrachtet.

Die horizontale Grundseite des Dreiecks liegt auf einer Höhe, die einer Impulsamplitude einer Stärke von 20% entspricht, die Spitze des Dreiecks liegt auf einer Höhe, die einer Impulsamplitude einer Stärke von 50% entspricht, das obere Ende des vertikalen Balkens liegt auf einer Höhe, die einer Impulsamplitude einer Stärke von etwa 80% entspricht, und das obere Ende des schrägen Balkens liegt auf einer Höhe, die einer Impulsamplitude einer Stärke von etwa 70% entspricht.

Bei einer Phasenlage von 240 bis 330° ist eine vergleichbare Anzahl von als Teilentladungs-Impuls-Matrixfeldern gesetzten Matrixfeldern dargestellt. Deren Form lässt sich ebenfalls charakterisieren durch ein Dreieck, von dessen oberer Spitze ein vertikaler Balken ausgeht, ein schräger Balken fehlt jedoch hier.

Die Grundseite des Dreiecks liegt auf einer Höhe, die einer Impulsamplitude einer Stärke von 20% entspricht, die Spitze des Dreiecks liegt auf einer Höhe, die einer Impulsamplitude einer Stärke von 50% entspricht, und das obere Ende des vertikalen Balkens liegt auf einer Höhe, die einer Impulsamplitude einer Stärke von etwa 80% entspricht.

Figur 3 zeigt eine Teilentladungsmatrix 8, die einen Ausschnitt der kompletten Ausgangs-Teilentladungsmatrix 6 darstellt.

Die Teilentladungsmatrix 8 der Fig. 3 ist eine isolierte Darstellung des umkreisten Bereichs der kompletten Ausgangs-Teilentladungsmatrix 6. Die darin als Teilentladungs-Impuls-Matrixfelder gesetzten Matrixfelder sind ebenfalls schwarz hinterlegt und entsprechen den Teilentladungs-Impuls-Matrixfeldern in dem umkreisten Bereich der kompletten Ausgangs-Teilentladungsmatrix 6. Die Teilentladungsmatrix 8 ist aus Gründen der Darstellung etwas in horizontaler Richtung gestreckt dargestellt und die als Teilentladungs-Impuls-Matrixfelder gesetzten Matrixfelder sind einzeln in Form einer Rasterdarstellung zu erkennen. Die Teilentladungsmatrix 8 in Fig. 3 bildet ein Raster von 17x20 Matrixfeldern.

Zur Verkürzung der Beschreibung werden die als Teilentladungs-Impuls-Matrixfelder gesetzten Matrixfelder im Folgenden TIMs genannt

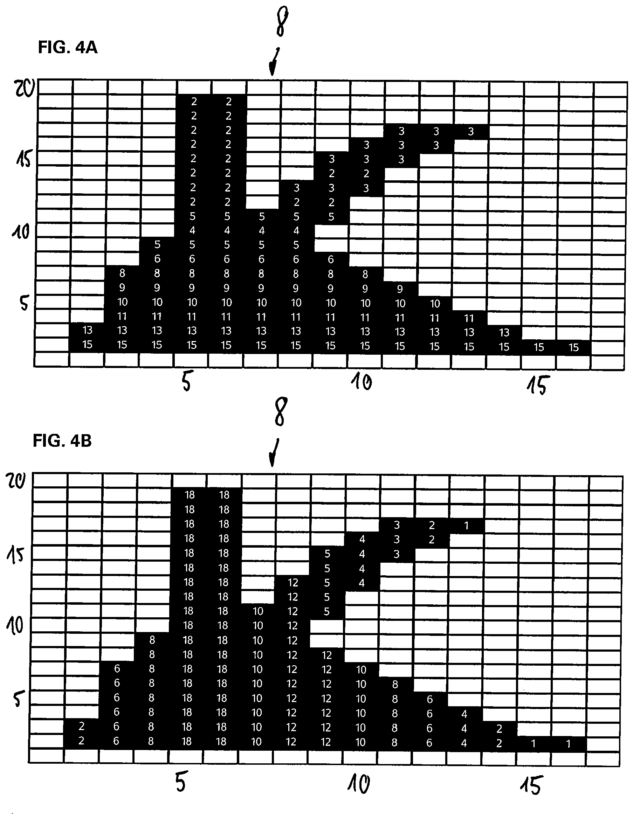

Figur 4a zeigt die Teilentladungsmatrix 8, deren Teilentladungs-Impuls-Matrixfelder mit dem Eigenschaftswert der horizontalen Kettenlänge beschriftet sind.

Gemäß Fig. 4a wird nun jedem TIM die Eigenschaft: Länge zusammenhängender TIMs in horizontaler Richtung zugeordnet.

Da in der zweiten Zeile 15 TIMs nebeneinander angeordnet sind, erhält jedes dieser TIMs den Eigenschaftswert Länge in horizontaler Richtung von 15. In der dritten Zeile sind 13 TIMs nebeneinander angeordnet, somit enthält jedes dieser TIMs den Eigenschaftswert: Länge in horizontaler Richtung 13, usw.

Die TIMs des an der Spitze des Dreiecks ansetzenden vertikalen Balkens und des an der Spitze des Dreiecks ansetzenden schrägen Balkens sind jeweils voneinander getrennt und erhalten somit nur den Eigenschaftswert der dort in horizontaler Richtung zusammenhängenden TIMs, nämlich 2 bzw. 3 in den Zeilen 12 bis 19.

Figur 4b zeigt die Teilentladungsmatrix 8, deren Teilentladungs-Impuls-Matrixfelder mit dem Eigenschaftswert der vertikale Kettenlänge beschriftet sind.

Analog zu Fig. 4a wird nun jedem Teilentladungs-Impuls-Matrixfeld der Eigenschaftswert: Länge zusammenhängender TIMs in vertikaler Richtung zugeordnet. Da in der zweiten Spalte zwei TIMs übereinander angeordnet sind, enthält jedes dieser beiden TIMs den Eigenschaftswert Länge in vertikaler Richtung 2, in Spalte 3 erhält jedes Teilentladungs-Impuls-Matrixfeld den Eigenschaftswert Länge in vertikaler Richtung 6, usw.

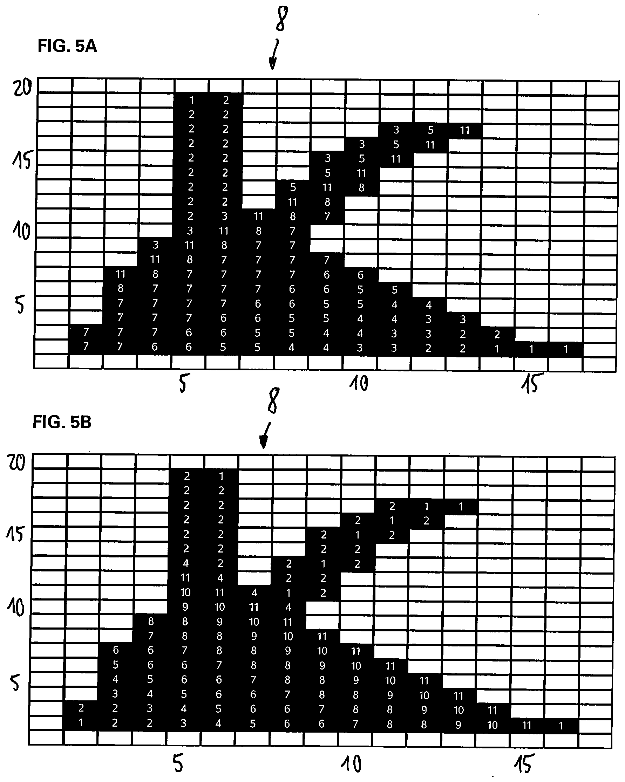

Figur 5a zeigt die Teilentladungsmatrix 8, deren Teilentladungs-Impuls-Matrixfelder mit dem Eigenschaftswert der diagonal steigenden Kettenlänge beschriftet sind.

Gemäß Fig. 5a erhält jedes TIM die Eigenschaft Länge der Kette zusammenhängender TIMs in diagonal steigender Richtung. Beispielsweise ist das TIM in Spalte 5, Zeile 19 das einzige TIM in diagonal steigender Richtung und bekommt somit den Eigenschaftswert Länge in diagonal steigende Richtung 1 zugeordnet. In der nach unten angrenzenden Diagonale in diagonal steigender Richtung befinden sich zwei TIMs, nämlich das TIM in Spalte 5, Zeile 18 und das TIM in Spalte 6, Zeilen 19, die beide den Eigenschaftswert Länge in diagonal steigende Richtung 2 zugeordnet bekommen, usw.

Figur 5b zeigt die Teilentladungsmatrix 8, deren Teilentladungs-Impuls-Matrixfelder mit dem Eigenschaftswert der diagonal fallenden Kettenlänge beschriftet sind.

Gemäß Fig. 5b wird jedem Teilentladungs-Matrixfeld die Eigenschaft Länge der Kette zusammenhängender Punkte in diagonal fallender Richtung zugeordnet. Bei dem TIM in Spalte 2, Zeile 2 ist dies der Eigenschaftswert Länge in diagonal fallende Richtung 1, bei den TIMs in Spalte 2, Zeile 3 und Spalte 3, Zeile 2 ist dies der Eigenschaftswert Länge in diagonal fallende Richtung 2, usw.

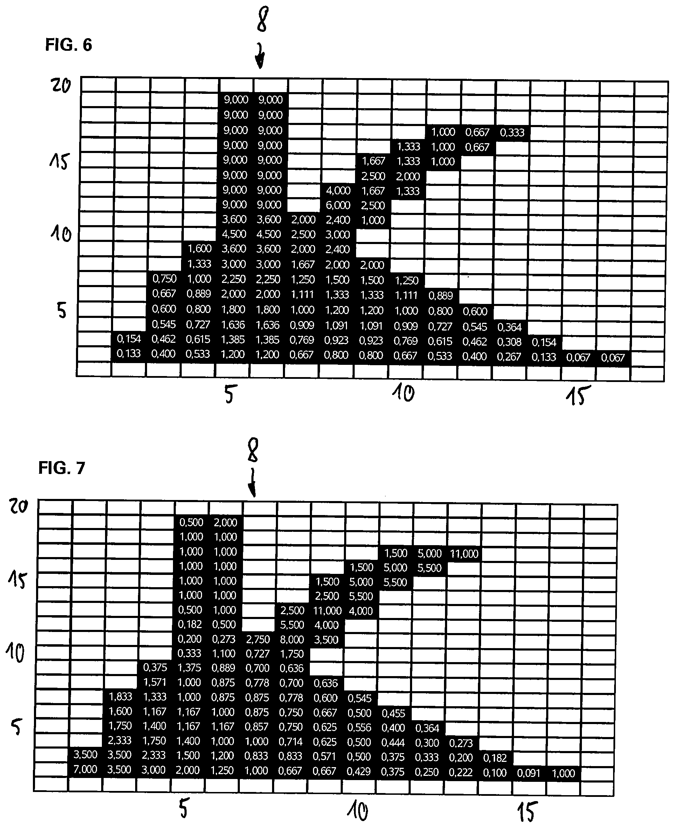

Figur 6 zeigt die Teilentladungsmatrix 8, deren Teilentladungs-Impuls-Matrixfelder mit dem abgeleiteten Eigenschaftswert des Kreuzaspekts beschriftet sind;

Gemäß Fig. 6 werden nun alle TIMs mit dem abgeleiteten Eigenschaftswert Kreuzaspekt versehen, der sich aus der Formel $KreuzAspekt = \frac{Länge vertikale Punktkette}{Länge horizontale Punktkette}$ ergibt.

Es wird also für jedes TIM dessen Eigenschaftswert Länge zusammenhängender TIMs in horizontale Richtung gemäß Fig. 4a durch dessen Eigenschaftswert Länge zusammenhängender TIMs in vertikale Richtung gemäß Fig. 4b geteilt.

Für das Teilentladungs-Matrixfeld in Spalte 2, Zeile 2 ergibt sich somit der abgeleitete Eigenschaftswert Kreuzaspekt zu 2 : 15 = 0,133; für das TIM in Spalte 2, Zeile 3 ergibt sich sein abgeleiteter Eigenschaftswert Kreuzaspekt zu 2 : 13 = 0,154; usw.

Figur 7 zeigt die Teilentladungsmatrix 8, deren Teilentladungs-Impuls-Matrixfelder mit dem abgeleiteten Eigenschaftswert des Diagonalaspekts beschriftet sind;

Gemäß Fig. 7 werden nun alle TIMs mit dem abgeleiteten Eigenschaftswert Diagonalaspekt versehen, der sich aus der Formel $DiagonalAspekt = \frac{Länge diagonal steigender Punktkette}{Länge diagonal fallender Punktkette}$ ergibt.

Es wird also jedem TIM der abgeleitete Eigenschaftswert Diagonalaspekt zugeordnet, der sich aus seinem Eigenschaftswert Länge in diagonal steigende Richtung gemäß Fig. 5a geteilt durch seinen Eigenschaftswert Länge in diagonal fallende Richtung gemäß Fig. 5b ergibt.

Der abgeleitete Eigenschaftswert Diagonalaspekt für das TIM in Spalte 2, Zeile 2 ergibt sich somit zu 7 : 1 = 7; für das TIM in Spalte 2, Zeile 3 ergibt sich der abgeleitete Eigenschaftswert Diagonalaspekt zu 7 : 2 = 3,5; usw.

Die abgeleiteten Eigenschaften Kreuzaspekt und Diagonalaspekt werden genutzt, um zu entscheiden, ob nebeneinander liegende TIMs zueinander gehören oder nicht.

Dazu werden die TIMs nacheinander durchgegangen, und ihnen werden die abgeleiteten Eigenschaften Kreuzabweichung, Diagonalabweichung und Abweichung zugeordnet, und zwar nach den folgenden Formeln: $KreuzAbweichung = abs \left(\frac{Minimum \left(KreuzAspekt Punkt,KreuzAspekt NachbarPunkt\right)}{Maximum \left(KreuzAspekt Punkt,KreuzAspekt NachbarPunkt\right)}-1\right)$ $DiagonalAbweichung = abs \left(\frac{Minimum \left(DiagonalAspekt Punkt,DiagonalAspekt NachbarPunkt\right)}{Maximum \left(DiagonalAspekt Punkt,DiagonalAspekt NachbarPunkt\right)}-1\right)$ $Abweichung = max \left(Kreuzabweichung, Diagonaabweichung\right)$

Das Durchgehen der TIMs kann nach einer beliebigen Reihenfolge erfolgen. In dem vorliegenden Ausführungsbeispiel wird beginnend links unten erst zeilen- und dann spaltenweise vorgegangen.

Nun wird nacheinander zu jedem TIM dasjenige horizontal, vertikal oder diagonal benachbarte TIM, also dasjenige Nachbar-TIM in der 3x3-Umgebung bestimmt, das die größte Abweichung aufweist, die jedoch noch kleiner als die maximal erlaubte Abweichung ist. Bei dieser Bestimmung werden die benachbarten TIMs nacheinander betrachtet, wobei die Reihenfolge der Betrachtung grundsätzlich beliebig ist.

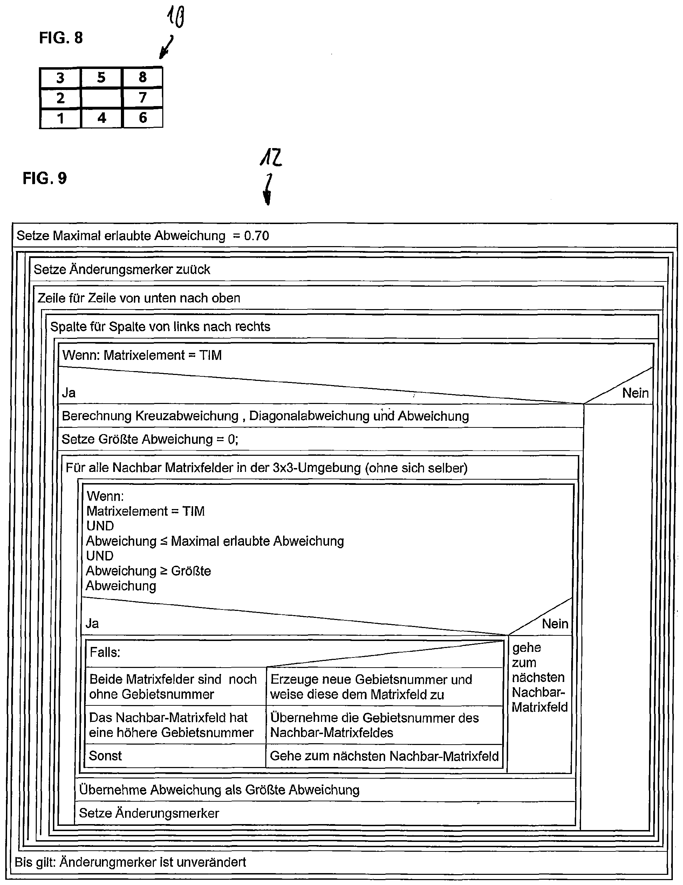

Figur 8 zeigt eine schematische Darstellung einer Abfrage-Reihenfolge 10 für jedes Teilentladungs-Impuls-Matrixfeld.

Bei der beispielhaften Abfrage-Reihenfolge 10 wird bei dem diagonal links unter dem betrachteten TIM liegenden benachbarten TIM begonnen, und es wird von unten nach oben und spaltenweise nach rechts vorgegangen.

Figur 9 zeigt ein Struktogramm eines iterativen Gebietszuordnungsverfahrens 12 für alle Teilentladungs-Impuls-Matrixfelder der Teilentladungsmatrix.

Gemäß dem Struktogramm wird wie folgt vorgegangen.

Zunächst wird eine maximal erlaubte Abweichung auf einen vorgegebenen Wert gesetzt, der im vorliegenden Ausführungsbeispiel 0,7 beträgt, dann wird ein Änderungsmerker zurückgesetzt.

Dann wird nacheinander für jedes TIM Zeile für Zeile von unten nach oben und Spalte für Spalte von links nach rechts die folgende Routine durchgeführt. Wenn das betrachtete Matrixfeld kein TIM ist, so wird mit der Betrachtung des nächsten Matrixfeldes fortgefahren.

Nur wenn das betrachtete Matrixfeld ein TIM ist, wird die folgende Subroutine durchgeführt.

Zunächst werden die Kreuzabweichung, die Diagonalabweichung und die Abweichung für dieses TIM berechnet, falls dies nicht schon vorher geschehen ist. Alternativ dazu können für alle TIMs die Kreuzabweichung, die Diagonalabweichung und die Abweichung vorab in einem Durchlauf berechnet worden sein.

Dann wird der Wert für die Variable größte Abweichung auf Null gesetzt.

Dann werden für das betrachtete TIM alle Nachbar-Matrixfelder in der 3x3-Umgebung nacheinander betrachtet, nach einer beliebigen Abfragereihenfolge, vorzugsweise nach der Abfragereihenfolge 10 gemäß Fig. 8.

Dabei wird überprüft, ob 1. das Nachbar-Matrixfeld ein TIM ist, ob 2. die Abweichung des Nachbar-TIMs kleiner gleich der maximal erlaubten Abweichung ist, 3. die Abweichung des Nachbar-TIMs größer gleich der größten Abweichung ist.

Wenn eine dieser drei Bedingungen nicht erfüllt ist, wird mit dem nächsten Nachbar-Matrixfeld fortgefahren.

Wenn alle drei Bedingungen erfüllt sind, dann wird dem betrachteten TIM eine Gebietsnummer zugeordnet, oder, falls dieses TIM schon eine Gebietsnummer hat, diese aktualisiert, und zwar wie folgt.

Dem TIM wird eine neue Gebietsnummer zugeordnet, wenn beide TIMs noch keine Gebietsnummer haben. Dem TIM wird die Gebietsnummer des Nachbar-TIMs zugeordnet, wenn die Gebietsnummer des Nachbar-TIMs größer ist als die Gebietsnummer des TIMs. Wenn keine dieser beiden Bedingungen erfüllt ist, wird die Gebietsnummer des TIMs beibehalten.

Diese Zuordnungsregel lautet demnach wie folgt: $\begin{matrix}Gebietsnummer \\ = { \begin{matrix}Neue Gebietsnummer , Beide Punkte ohne Gebietsnummer \\ Gebiet Nachbarpunkt , Gebietsnummer Nachbarpunkt > Derzeitige Gebietsnummer \\ Derzeitige Gebietsnummer , in allen anderen F ä llen\end{matrix}\end{matrix}$

Wenn für ein Nachbar-TIM die Abweichung größer ist, als die bisher größte Abweichung und außerdem noch kleiner ist, als die maximal erlaubte Abweichung, so wird die aktuelle Abweichung als größte Abweichung übernommen.

Hat das Nachbar-TIM selbst noch keine Gebietsnummer, enthält nur das TIM selbst eine neue Gebietsnummer. Das Nachbar-TIM erhält erst dann eine Gebietsnummer, wenn es selbst mit seinem Nachbar-TIM verglichen wird.

Wenn für ein TIM alle Nachbar-TIMs abgehandelt worden sind und wenn dem TIM eine neue Gebietsnummer zugewiesen worden ist oder für das betrachtete TIM die Gebietsnummer des Nachbar-TIMs übernommen worden ist, wird ein Änderungsmerker gesetzt.

Dann wird mit dem nächsten TIM gemäß der Reihenfolge Spalte für Spalte von links nach rechts und Zeile für Zeile von unten nach oben fortgefahren.

Diese Routine wird somit für alle Matrixfelder der Teilentladungsmatrix durchlaufen.

Nach einem kompletten Durchlauf aller Matrixfelder der Teilentladungsmatrix wird überprüft, ob sich der Änderungsmerker verändert hat.

Falls ja, wird der Änderungsmerker zurückgesetzt und die komplette Teilentladungsmatrix wird erneut nach der hier beschriebenen Routine durchlaufen.

Dies erfolgt so lange, bis nach einem kompletten Durchlauf der Teilentladungsmatrix der Änderungsmerker unverändert ist, was ein Hinweis darauf ist, dass sich keine Änderung in der Zuordnung der Gebietsnummern mehr ergeben hat. Dann ist die Zuordnung der TIMs zu mindestens einem geschlossenen Gebiet fertig.

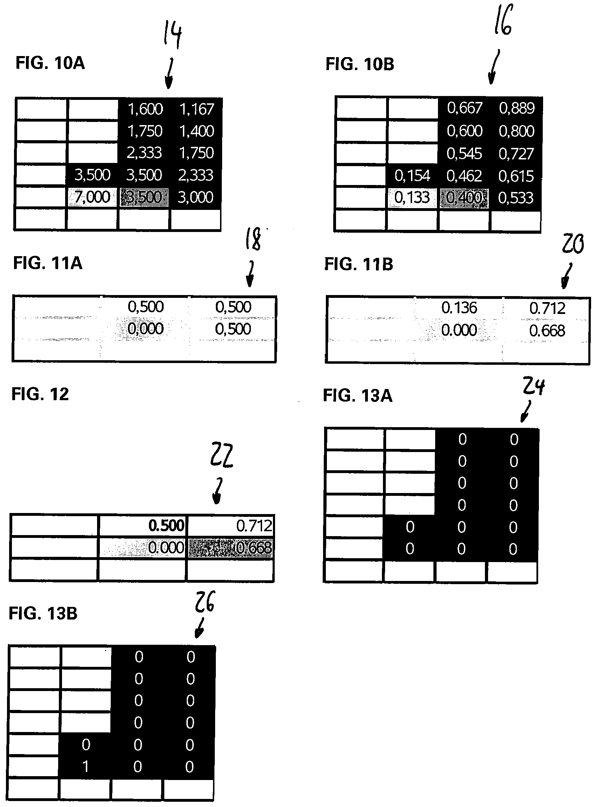

Einen beispielhaften Durchlauf der Routine iterative Gebietszuordnung gemäß Fig. 9 ist nachfolgend mit Bezug auf die Figuren 10a bis 13b dargestellt.

Figur 10a zeigt eine 4x6-Teilmatrix Diagonalaspekt 14 der Teilentladungsmatrix 8 aus Figur 7, deren Teilentladungs-Impuls-Matrixfelder mit dem abgeleiteten Eigenschaftswert des Diagonalaspekts beschriftet sind.

Die Teilmatrix Diagonalaspekt 14 ist ein 4x6-Ausschnitt des linken unteren Bereichs der Teilentladungsmatrix 8 gemäß Fig. 7, deren TIMs mit der abgeleiteten Eigenschaft Diagonalaspekt beschriftet sind. Dabei sind die TIMs in Zeile 2, Spalten 2 und 3 durch einen hellen Hintergrund hervorgehoben.

Figur 10b zeigt eine 4x6-Teilmatrix Kreuzaspekt 16 der Teilentladungsmatrix aus Figur 6, deren Teilentladungs-Impuls-Matrixfelder mit dem abgeleiteten Eigenschaftswert des Kreuzaspekts beschriftet sind

Die Teilmatrix Kreuzaspekt 16 ist ein 4x6-Ausschnitt des linken unteren Bereichs der Teilentladungsmatrix 8 aus Fig. 6, deren TIMs mit der abgeleiteten Eigenschaft Kreuzaspekt beschriftet sind. Die TIMs in Zeile 2, Spalten 2 und 3 sind durch einen helleren Hintergrund hervorgehoben.

Nachfolgend wird zur Erläuterung das TIM in Zeile 2, Spalte 2 betrachtet.

Figur 11a zeigt eine Berechnungsmatrix Diagonalabweichung 18 des Teilentladungs-Impuls-Matrixfelds in Zeile 2, Spalte 2 zu den benachbarten Teilentladungs-Impuls-Matrixfeldern.

Die Berechnungs-Teilmatrix Diagonalabweichung 18 gemäß Fig. 11a ist nun ein 3x3-Ausschnitt des linken unteren Bereichs der Teilentladungsmatrix 8 aus Fig. 7 bzw. der Teilmatrix Diagonalaspekt 14 aus Fig. 10a, wobei die benachbarten TIMs des TIM in Zeile 2, Spalte 2 mit der berechneten abgeleiteten Eigenschaft Diagonalabweichung beschriftet sind.

Für das benachbarte TIM in Zeile 3, Spalte 2 ergibt sich unter Anwendung der Formel Diagonalabweichung die Diagonalabweichung zu $abs \left(min\left(7,000, 3,500\right)/max\left(7,000, 3,500\right)-1\right) = abs \left(3,500/7,000-1\right) = 0,5 .$

Dieser Wert für die Diagonalabweichung wird dem TIM in Spalte 2, Zeile 3, das dem betrachteten TIM in Spalte 2, Zeile 2 benachbart ist, zugeordnet.

Da die Werte für die Diagonalabweichung für die dem TIM in Spalte 2, Zeile 2 benachbarten TIMs in Spalte 3, Zeile 2 und Spalte 3, Zeile 3 ebenfalls 3,500 betragen, ergibt sich für diese benachbarten TIMs der gleiche Wert für die Diagonalabweichung von 0,5.

Figur 11b zeigt eine Berechnungsmatrix Kreuzabweichung 20 des Teilentladungs-Impuls-Matrixfelds in Zeile 2, Spalte 2 zu den benachbarten Teilentladungs-Impuls-Matrixfeldern;

Die Berechnungs-Teilmatrix Kreuzabweichung 20 gemäß Fig. 11b ist eine 3x3-Teilmatrix, die den Ausschnitt des linken unteren Bereichs der Teilentladungsmatrix 8 aus Fig. 6 bzw. der Berechnungs-Teilmatrix Kreuzaspekt 16 aus Fig. 10b darstellt, und deren TIMs mit der abgeleiteten Eigenschaft Kreuzaspekt beschriftet sind.

Unter Anwendung der Formel Kreuzabweichung wird nun für die TIMs in Spalte 2, Zeile 3, in Spalte 3, Zeile 2 und in Spalte 3, Zeile 3, die dem betrachteten TIM in Spalte 2, Zeile 2 benachbart sind, die abgeleitete Eigenschaft Kreuzabweichung berechnet, und diese benachbarten TIMs werden mit dieser abgeleiteten Eigenschaft Kreuzabweichung versehen.

Für das benachbarte TIM in Spalte 2, Zeile 3 ergibt sich unter Anwendung der Formel Kreuzabweichung die Kreuzabweichung zu $abs \left(min\left(0,133, 0,154\right)/max\left(0,133, 0,154\right)-1\right) = abs \left(\left(0,133/0,154\right)-1\right) = 0,136$

Für das benachbarte TIM in Spalte 3, Zeile 2 ergibt sich die abgeleitete Eigenschaft Kreuzaspekt, mit der dieses TIM versehen wird zu $abs \left(min\left(0,133, 0,400\right)/max\left(0,133, 0,400\right)-1\right) = abs \left(\left(0,133/0,400\right)-1\right) = 0,668 .$

Analog dazu ergibt sich für das benachbarte TIM in Spalte 3, Zeile 3 die abgeleitete Eigenschaft Kreuzabweichung, die diesem TIM zugeordnet wird, zu 0,462.

Figur 12 zeigt eine Berechnungsmatrix Abweichung des Teilentladungs-Impuls-Matrixfelds in Zeile 2, Spalte 2 zu den benachbarten Teilentladungs-Impuls-Matrixfeldern;

Die Berechnungsmatrix Abweichung 22 gemäß Fig. 12 bildet eine 3x3-Teilmatrix, die den Ausschnitt des linken unteren Bereichs der Teilentladungsmatrix 8 aus Fig. 6 darstellt. Die Berechnungsmatrix Abweichung 22 ergibt sich unter Anwendung der Formel Abweichung auf die Berechnungs-Teilmatrix Diagonalabweichung 18 aus Fig. 11a und auf die Berechnungs-Teilmatrix Kreuzabweichung 20 aus Fig. 11b.

Gemäß der Formel Abweichung wird den TIMs in Spalte 2, Zeile 3, in Spalte 3, Zeile 2 und in Spalte 3, Zeile 3, die dem betrachteten TIM in Spalte 2, Zeile 2 benachbart sind, der Maximalwert aus Kreuzabweichung und Diagonalabweichung, also der größere der beiden Werte des gleichen TIMs aus Fig. 11a und Fig. 11b zugewiesen.

Somit ist der Abweichungswert für das benachbarte TIM in Spalte 2, Zeile 3
max (0,500 ; 0,136) = 0,500,
der Abweichungswert für das benachbarte TIM in Spalte 3, Zeile 2 ist
max (0,500 ; 0,668) = 0,668,
und der Abweichungswert für das benachbarte TIM in Spalte 3, Zeile 3 ist
max (0,500 ; 0,712) = 0,712.

Figur 13a zeigt eine Teilmatrix Gebietsnummer am Anfang 24 der Teilentladungsmatrix 8, deren Teilentladungs-Impuls-Matrixfelder mit ihrer Gebietsnummer am Anfang des iterativen Gebiets-Zuordnungsverfahrens gemäß Figur 9 beschriftet sind.

Die Teilmatrix Gebietsnummer am Anfang 24 gemäß Fig. 13a ist eine 4x7-Teilmatrix, die einem Ausschnitt des linken unteren Bereichs der Teilentladungsmatrix 8 darstellt, und deren TIMs ganz zu Beginn des iterativen Gebietszuordnungsverfahrens gemäß Fig. 9 noch kein Gebiet zugeordnet worden ist und deren TIMs mit der Gebietsnummer 0 versehen sind.

Figur 13b zeigt eine Teilmatrix nach Gebietszuordnung 26 für erstes Teilentladungs-Impuls-Matrixfeld der Teilentladungsmatrix 8, deren Teilentladungs-Impuls-Matrixfelder mit ihrer Gebietsnummer nach einem Teildurchlauf des iterativen Gebiets-Zuordnungsverfahrens gemäß Figur 9 beschriftet sind.

Gemäß der Teilmatrix nach Gebietszuordnung 26 ist nun dem TIM in Spalte 2, Zeile 2 die Gebietsnummer 1 zugeordnet worden.

Gemäß Anwendung des Struktogramms iteratives Gebietszuordnungsverfahren 12 ist dies wie folgt geschehen.

Die maximal erlaubte Abweichung wird zunächst auf 0,7 gesetzt und der Änderungsmerker wird zurückgesetzt.

Dann wird zunächst die erste Zeile der Teilentladungsmatrix 8 von links nach rechts durchlaufen, wobei die Überprüfung für jedes Matrixfeld ergibt, dass es sich dabei nicht um ein TIM handelt, und daher immer sukzessive mit dem nächsten Matrixfeld fortgefahren wird.

Dann wird die zweite Zeile der Teilentladungsmatrix 8 von links nach rechts durchlaufen. Für das Matrixfeld in der zweiten Zeile, erste Spalte ergibt die Überprüfung, dass es sich dabei nicht um ein TIM handelt, und daher wird mit Matrixfeld in der zweiten Zeile, zweite Spalte fortgefahren.

Für das Matrixfeld in der zweiten Zeile, zweite Spalte ergibt die Überprüfung, dass es sich dabei um ein TIM handelt

Für dieses Matrixfeld und für die benachbarten Matrixfelder, sofern sie TIMs sind, werden die abgeleiteten Eigenschaftswerte Kreuzabweichung, Diagonalabweichung und Abweichung berechnet. Die hierfür erforderlichen Eigenschaftswerte horizontale Kettenlänge, vertikale Kettenlänge, diagonal steigende Kettenlänge, diagonal fallende Kettenlänge, Kreuzaspekt und Diagonalaspekt sind bereits zuvor berechnet und geeignet zwischengespeichert worden.

Alternativ dazu können für alle TIMs die abgeleiteten Eigenschaftswerte Kreuzabweichung, Diagonalabweichung und Abweichung bereits vor Durchführung dieses iterativen Gebietszuordnungsverfahrens berechnet worden sein.

Die größte Abweichung wird nun auf Null gesetzt.

Dann werden die Matrixfelder betrachtet, die dem TIM in Spalte 2, Zeile 2 benachbart sind, und zwar nach der Abfragereihenfolge 10.

Da bei den Nachbar-Matrixfeldern in Spalte 1, Zeile 1, in Spalte 1, Zeile 2, in Spalte 1, Zeile 3 und in Spalte 2, Zeile 1 jeweils die Bedingung Nachbar-Matrixfeld = TIM nicht erfüllt ist, wird sukzessive das nächste Nachbar-Matrixfeld betrachtet.

Bei dem Nachbar-Matrixfeld in Spalte 2, Zeile 3 ergibt die Überprüfung, dass es ein TIM ist, dass dessen Abweichung 0,5 kleiner als die maximal erlaubte Abweichung von 0,7 ist und dass dessen Abweichung größer als die auf 0 gesetzte größte Abweichung ist.

Da nun alle drei Bedingungen erfüllt sind, wird überprüft ob beide Matrixfelder, also das TIM in Spalte 2, Zeile 2 und das benachbarte TIM in Spalte 2, Zeile 3 noch ohne Gebietsnummer sind, und dabei wird festgestellt, dass dies der Fall ist. Dementsprechend wird eine neue Gebietsnummer, hier die nächste aufsteigende Gebietsnummer 1 erzeugt, und diese Gebietsnummer wird dem TIM in Spalte 2, Zeile 2 zugeordnet, wie dies in der Teilmatrix-Gebietsnummer nach erstem Zuordnungsschritt 28 dargestellt ist.

Hätte nun das TIM in Spalte 2, Zeile 3 eine höhere Gebietsnummer gehabt als das betrachtete TIM in Zeile 2, Spalte 2 wäre dem TIM in Spalte 2, Zeile 2 gemäß der Anweisung "Übernehme die Gebietssumme des Nachbar-Matrixfelds" dessen Gebietsnummer zugeordnet worden.

Dann wird die Abweichung 0,5 als größte Abweichung übernommen und ein Änderungsmerker wird gesetzt. Nun wird mit der Prüfung des nächsten Nachbar-Matrixfelds fortgefahren.

Dies ist das Nachbar-Matrixfeld in Spalte 3, Zeile 1, bei dem die Bedingung Nachbar-Matrixfeld = TIM nicht erfüllt ist, sodass das nächste Nachbar-Matrixfeld in Spalte 3, Zeile 2 betrachtet wird.

Bei dem Nachbar-Matrixfeld in Spalte 3, Zeile 2 sind ebenfalls alle drei Bedingungen erfüllt, denn dieses Matrixfeld ist ein TIM, seine Abweichung 0,668 ist kleiner gleich die maximal erlaubte Abweichung von 0,700 und sie ist auch größer als die größte Abweichung 0,500. Dementsprechend wird überprüft, ob beide Matrixfelder noch ohne Gebietsnummer sind, was nicht der Fall ist, da ja das TIM in Spalte 2, Zeile 2 auf die Gebietsnummer 1 gesetzt worden ist. Danach wird überprüft ob das Nachbar-TIM in Spalte 3, Zeile 2 eine höhere Gebietsnummer hat, was ebenfalls nicht der Fall, denn es hat ja mit der Gebietsnummer 0 eine niedrigere Gebietsnummer als das TIM in Spalte 2, Zeile 2.

Dementsprechend wird mit dem Nachbar-Matrixfeld in Spalte 3, Zeile 3 fortgefahren. Dieses Nachbar-Matrixfeld ist zwar ein TIM, aber die Bedingung Abweichung kleiner gleich maximal erlaubte Abweichung ist nicht erfüllt, da der Abweichungswert von 0,712 für dieses TIM größer ist, als die maximal erlaubte Abweichung 0,70.

Nach Betrachtung aller Nachbar-Matrixfelder für das TIM in Spalte 2, Zeile 2 ergibt sich somit das Zwischenergebnis der Gebietszuordnung für die TIMs, wie es in der Teilmatrix nach Gebietszuordnung 26 dargestellt ist.

Nun wird gemäß dem Struktogramm iteratives Zuordnungsverfahren 12 mit dem nächsten TIM fortgefahren. Dies ist gemäß der Durchlaufroutine Zeile für Zeile von unten nach oben und Spalte für Spalte von links nach rechts das TIM in Spalte 2, Zeile 3.

Die Gebietszuordnung für dieses TIM sowie für alle weiteren TIMs erfolgt durch Anwendung des Verfahrens gemäß Struktogramm iteratives Gebietszuordnungsverfahren 12 aus Fig. 9 analog der Gebietszuordnung, wie sie mit Bezug auf das TIM in Spalte 2, Zeile 2 beschrieben worden ist. Dies ist für den Fachmann ohne Weiteres verständlich, und auf eine weitere Darstellung wird aus Platzgründen verzichtet.

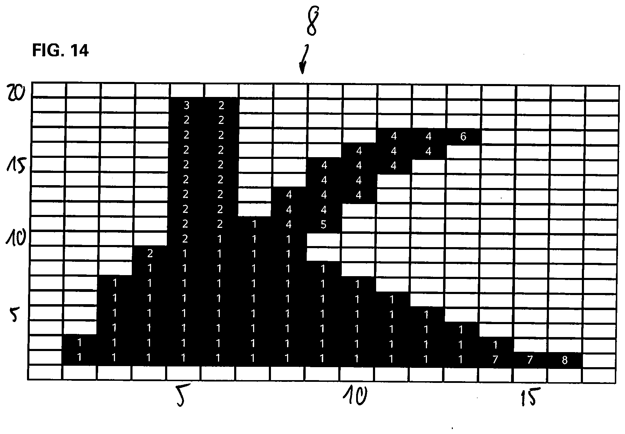

Fig. 14 zeigt die Teilentladungsmatrix 8 wobei den TIMs durch einen vollständigen Durchlaufs des iterativen Gebietszuordnungsverfahrens, wie es mit Bezug auf die Figuren 9 bis 13b beschrieben worden ist, Gebiete zugeordnet worden sind.

Wie zu sehen ist, sind insgesamt acht verschiedene Gebiete zugeordnet worden.

Das Gebiet 1 besteht aus den TIMs in Zeile 2, Spalten 2 bis 13, aus den TIMs der Zeilen 3, 4, 5, 6, 7 und 8, aus den TIMs der Zeile 9, Spalten 5 bis 8, aus den TIMs der Zeile 10, Spalten 6 bis 8, und aus dem TIM der Zeile 11, Spalte 7.

Das Gebiet 2 besteht aus dem TIMs der Zeile 9, Spalte 4, aus den TIMs der Spalte 5, Zeilen 10 bis 18 und aus den TIMs der Spalte 6, Zeilen 11 bis 19.

Das Gebiet 3 besteht aus dem TIMs der Zeile 19, Spalte 5.

Das Gebiet 4 besteht aus den TIMs der Spalte 8, Zeilen 11 bis 13, Spalte 9, Zeilen 12 bis 15, Spalte 10, Zeilen 13 bis 16, Spalte 11, Zeilen 15 bis 17, Spalte 12, Zeilen 16 bis 17.

Das Gebiet 5 besteht aus dem TIM in Zeile 11, Spalte 9.

Das Gebiet 6 besteht aus dem TIM in Zeile 17, Spalte 13.

Das Gebiet 7 besteht aus den TIMs in Zeile 2, Spalten 14 und 15.

Das Gebiet 8 besteht aus dem TIM in Zeile 2, Spalte 16.

Für die weitere Betrachtung werden nun in einem optionalen Entfernungsschritt diejenigen Gebiete entfernt, die aus weniger als 10 TIMs bestehen und deren Ausdehnung weder in vertikaler noch in horizontaler Richtung einen Wert von 8 überschreitet, wobei diese Grenzwerte selbstverständlich auch anders gewählt werden können. Solche zu entfernenden Gebiete werden als geringfügig betrachtet.

Gemäß Fig. 14 handelt es sich bei diesen als geringfügig betrachteten Gebieten um die Gebiete 5 bis 8.

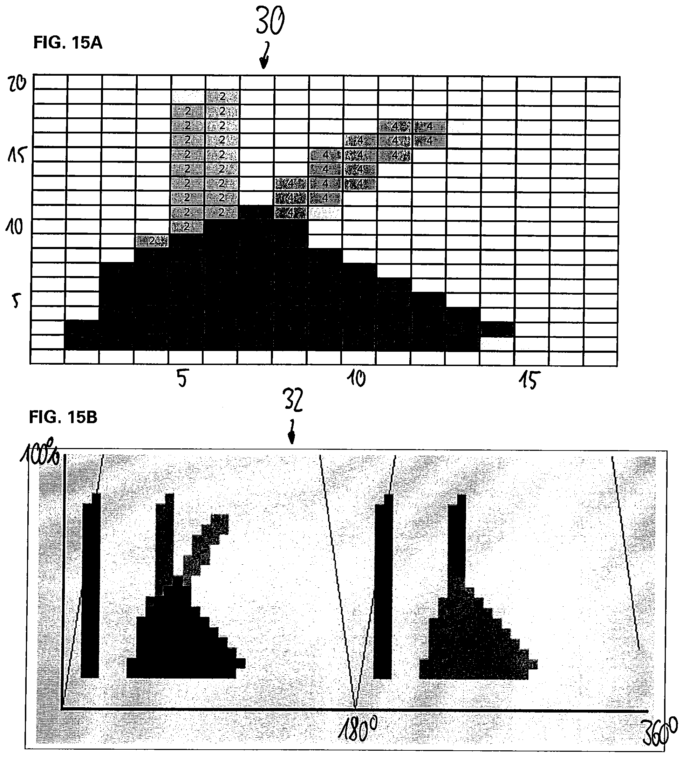

Fig. 15a zeigt eine Teilentladungsmatrix 30 nach Gebietszuordnung der Teilentladungs-Impuls-Matrixfelder und nach Entfernen der zu kleinen, als geringfügig betrachteten Gebiete von Teilentladungs-Impuls-Matrixfeldern.

Die Teilentladungsmatrix 30 ergibt sich aus der Teilentladungsmatrix 8, wobei deren TIMs mit den Nummern des jeweiligen Gebiets beschriftet sind, denen diese Teilentladungs-Impuls-Matrixfelder nach kompletten Durchlauf des iterativen Gebietszuordnungsverfahrens gemäß Figur 9 zugeordnet worden sind, und wobei diejenigen TIMs entfernt worden sind, deren Gebiet eine zu kleine Ausdehnung hat;

Wie gut zu sehen ist, sind die TIMs somit in drei relevante Gebiete eingeordnet worden, nämlich in das Gebiet 1, in das Gebiet 2 und in das Gebiet 4. Das Gebiet 1 hat - grob gesprochen - die Form eines Dreiecks, das Gebiet 2 hat - grob gesprochen - die Form eines vertikalen Balkens, der sich von der Spitze des Dreiecks nach oben erstreckt, und das Gebiet 4 hat - grob gesprochen - die Form eines Balkens, der sich von der Spitze des Dreiecks nach rechts oben erstreckt.

Figur 15b zeigt eine komplette Ausgangs-Teilentladungsmatrix 32, deren Teilentladungs-Impuls-Matrixfelder verschiedenen Gebieten zugeordnet worden sind und wobei die zu kleinen, als geringfügig betrachteten Gebiete von Teilentladungs-Impuls-Matrixfeldern entfernt worden sind.

Nachdem die Gebietszuordnung nun exemplarisch für den umrandeten Bereich der kompletten Ausgangs-Teilentladungsmatrix 6 erläutert worden ist, ist nun in Fig. 15b die komplette Ausgangs-Teilentladungsmatrix 6 nach erfolgter Gebietszuordnung dargestellt. Die jeweils erkannten zusammenhängenden Gebiete sind farblich hinterlegt.

In Fig. 15b ist gut zu erkennen, dass die vertikalen Balken bei den Phasenlagen von 20° und 200° jeweils als zusammenhängende Gebiete, die Grunddreiecke der Menge der TIMs bei den Phasenlagen von 40 bis 120° und 220 bis 300° jeweils als zusammenhängende Gebiete, die vertikalen Balken, die sich bei den Phasenlagen von 60° bis 70° und 240° bis 250° von der Spitze der Dreiecke nach oben erstrecken, jeweils als zusammenhängende Gebiete, und der sich von der Spitze des linken Dreiecks schräg nach oben erstreckende Balken bei der Phasenlage von 80 bis 100° als zusammenhängendes Gebiet identifiziert worden sind.

Die gemäß Fig. 15a entfernten, zu kleinen Gebiete sind in Fig. 15b hell hinterlegt dargestellt.

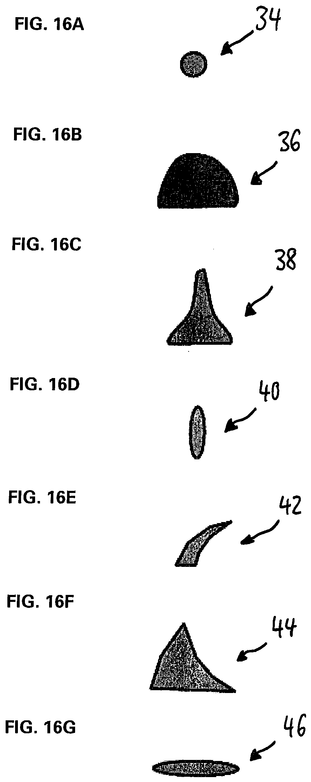

Figur 16a zeigt eine schematische Darstellung der Grundform Punkt 34; Figur 16b zeigt eine schematische Darstellung der Grundform Hügel 36; Figur 16c zeigt eine schematische Darstellung der Grundform Flamme 38; Figur 16d zeigt eine schematische Darstellung der Grundform Turm 40; Figur 16e zeigt eine schematische Darstellung der Grundform Sichel 42; Figur 16f zeigt eine schematische Darstellung der Grundform Flosse 44; und Figur 16g zeigt eine schematische Darstellung der Grundform Ebene 46.

In den Figuren 16a bis 16g sind charakteristische Grundformen von TIMs dargestellt und beschrieben. Diese Grundformen können anhand einer Verknüpfung von Kriterien, die in Kombination miteinander erfüllt sein müssen, mathematisch beschrieben werden.

Dabei wird auf bestimmte Grundformen zurückgegriffen, die im Folgenden nicht abschließend aufgezählt sind:
Area Share /Bedeckungsgrad: Anzahl TIMs/Anzahl aller Matrixelemente des umhüllenden Rechtecks;
Aspect/Seitenverhältnis des umhüllenden Rechtecks: vertikale Ausdehnung/horizontale Ausdehnung;
Free Corners: Feststellung, in wie vielen Ecken des umhüllenden Rechtecks alle Zellen frei sind;
Free Sides/Freie Seitenmitten: Feststellen, in wie vielen Seitenmitten des umhüllenden Rechtecks alle Zellen frei sind;
Krümmung:
   Left Turn/linke Hüllkurve = minₓy;
   Top Turn/obere Hüllkurve = max_{y}x;
   Right Turn/rechte Hüllkurve = maxₓy;
   Bottom Turn/untere Hüllkurve = min_{y}x
Symmetrie:
   V-Sym: Symmetrie um vertikale Mittenachse
   H-Sym: Symmetrie um horizontale Mittenachse

Die Grundform Punkt/Spot 34 ist durch die folgende Kombination von Bedingungen definiert.

Spot := AreaShare>=0.78 && (FreeCorners>=3 ∥ FreeCorners<=1) && FreeSides<=0 && Aspect<2 && Aspect>0.5

In dieser Formel und in allen weiteren Formeln bezeichnet der operator ∥ eine ODER-Verknüpfung

Die Grundform Hügel/Hill 36 ist durch die Kombination der folgenden Bedingungen definiert.

Hill := AreaShare==0.64 && FreeCorners==2 && (FreeSides==2 ∥ FreeSides==0) && Aspect>=0.25 && Aspect<=4 && LeftTurn>0 && (RightTurn<0 ∥ V-Sym==1) && BottomTurn>=0 && H-Sym!=1

Die Grundform Flamme/Flame 38 ist durch die Kombination der folgenden Bedingungen definiert.

Flame := AreaShare<=0.40 && Aspect>=1.0 && FreeCorners<=2 && FreeSides>=2 && FreeSides<=3 && BottomTurn==0 && LeftTurn<0 && RightTurn>0

Die Grundform Turm/Tower 40 ist durch die Kombination der folgenden Bedingungen definiert.

Tower:= AreaShare >= 0.78 && Aspect >= 3 && LeftTurn >= 0 && RightTurn <= 0

Die Grundform Sichel/Sickle 42 ist durch die Kombination der folgenden Bedingungen definiert.

Sickle := AreaShare<=0.35 && FreeCorners==2 && FreeSides>=3 && LeftTurn>0 && RightTurn>0 && BottomTurn>0 && TopTurn<0

Die Grundform Flosse/Fin 44 ist durch die Kombination der folgenden Bedingungen definiert.

Fin := AreaShare==0.50 && Aspect<3 && Aspect>0.33 && FreeCorners<=2 && Free-Sides>=l && FreeSides<=3 && BottomTurn>=0 && LeftTurn>=0 && (RightTurn>=0 ∥ V-Sym<=0.75)

Die Grundform Ebene/Platform 46 ist durch die Kombination der folgenden Bedingungen definiert.

Platform := AreaShare==0.78 && Aspect<0.25 && BottomTurn>=0 && TopTurn<=0 && H-Sym==1

In den Figuren 16a bis 16g sind nur beispielhaft einige Grundformen dargestellt. Die Darstellung erhebt keinen Anspruch auf Vollständigkeit, es können noch eine Vielzahl beliebiger weiterer Grundformen hinterlegt sein.

Beispielsweise kann eine Grundform Bogen/Arch vorgesehen sein, die durch die Kombination der folgenden Bedingungen definiert ist.

Arch := AreaShare<=0.50 && FreeCorners>=2 && FreeCorners<=3 && (FreeSides==1 ∥ FreeSides==3) && BottomTurn<0

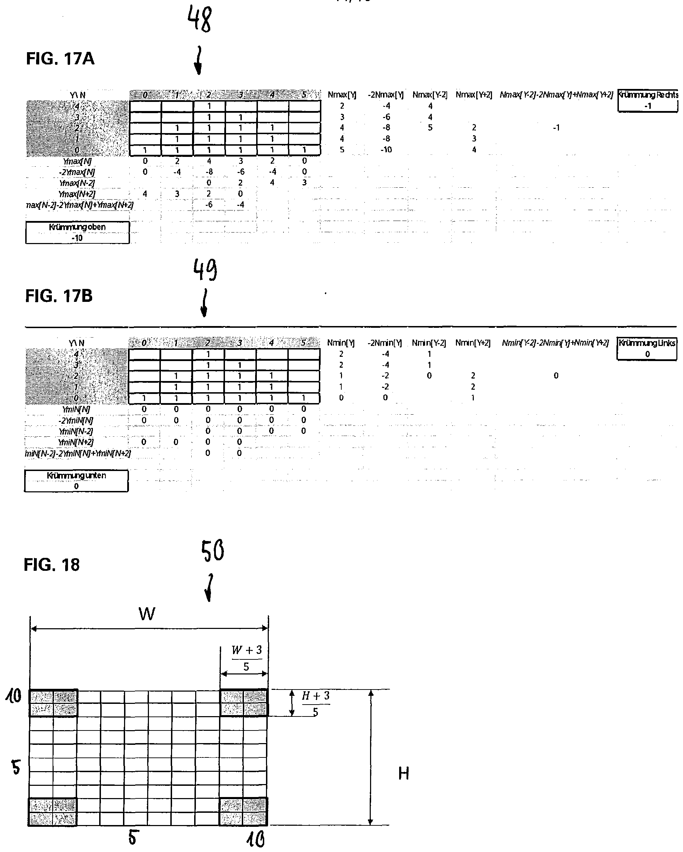

Beispiele für die Berechnung der Free Corners, der Free Sides, der Krümmung und der Symmetrie sind nachfolgend mit Bezug auf die Figuren 17 bis 20 gegeben. Bei den Berechnungsbeispielen der Figuren 17 bis 20 handelt es sich der einfacheren Darstellung wegen um Berechnungsbeispiele, die sich nicht auf ein Gebiet gemäß der Teilentladungsmatrix mit Gebietszuordnung 30 aus Fig. 15a beziehen, sondern einfacher sind.

Figur 17a zeigt eine beispielhafte Berechnungsmatrix 48 zur Berechnung der Krümmung oben und rechts einer Hüllkurve.

Die beispielhafte Berechnungsmatrix Hüllkurve 48 in der Fig. 17a und auch die beispielhafte Berechnungsmatrix Hüllkurve 49 in der Fig. 17b gehen von einer Gruppe von zusammenhängendem TIMs aus, wie sie gemäß dem zuvor beschriebenen iterativen Gebietszuordnungs-Verfahren bestimmt worden ist. Diese Gruppe von TIMs ist nachfolgend in einer 6x5-Matrix dargestellt.

Der Index der höchsten besetzten Zeile einer Spalte (größter TIM) ist in der darunter befindlichen Zeile ymax[n] dargestellt. Da in Fig. 17 in der ersten Spalte der oberste TIM in Zeile "0" ist, erhält ymax[n] für die erste Spalte den Wert 0, da in der zweiten Spalte der oberste TIMs in Zeile "2" steht, erhält y[n] für die zweite Spalte den Wert 2, usw.

In der Zeile -2ymax[n] ist der Wert aus der darüber liegenden Zeile ymax[n] jeweils mit dem Faktor -2 multipliziert worden.

In der Zeile ymax[n-2] ist der Wert für das zwei Kästchen weiter links liegende Kästchen für ymax[n-2] eingetragen. Da in der Spalte 0 und der Spalte 1 das jeweils zwei Kästchen weiter links liegende Kästchen nicht mit einem Wert versehen ist, erhalten diese Kästchen jeweils keinen Wert bzw. den Wert 0. Da in der Spalte 2 das zwei Kästchen weiter links liegende Kästchen den Wert 0 hat, erhält dieses Kästchen den Wert 0, da in der Spalte 3 das zwei Kästchen weiter links liegende Kästchen ymax[n] den Wert 2 hat, erhält dieses Kästchen den Wert 2, usw.

In der Zeile ymax[n+2] ist der Wert für das zwei Kästchen weiter rechts liegende Kästchen ymax[n+2] eingetragen. Da in der Spalte 0 das zwei Kästchen weiter rechts liegende Kästchen ymax[n] den Wert 4 hat, erhält dieses Kästchen den Wert 4, da in der Spalte 1 das zwei Kästchen weiter rechts liegende Kästchen ymax[n] den Wert 3 hat, erhält dieses Kästchen den Wert 3, usw.

Analog dazu ist der Index der höchsten besetzten Spalte einer Zeile in der rechts daneben befindlichen Spalte nmax[y] dargestellt. Da in der ersten Zeile der am weitesten rechts gelegene TIM in der Spalte 2 ist, erhält nmax[y] den Wert 2, da in der zweiten Zeile das am weitesten rechts gelegene TIM in der Spalte 3 ist, erhält nmax[y] den Wert 3, usw.

In der Spalte -2nmax[y] sind diejenigen Werte eingetragen, die sich aus einer Multiplikation der Werte in der Spalte nmax[y] mit dem Faktor -2 ergeben.

In der Spalte nmax[y-2] sind diejenigen Werte eingetragen, die sich in den jeweils zwei Kästchen darunter liegenden Kästchen befinden. In der ersten Spalte befindet sich in der Spalte nmax[y-2] der Wert 4, da in der Spalte nmax[y] zwei Kästchen darunter der Wert 4 ist, usw.

In der Spalte nmax[y+2] sind diejenigen Werte eingetragen, die sich in den jeweils zwei Kästchen darüber liegenden Kästchen befinden.

Unter Anwendung der Formeln $K r ü mmung oben = {\sum }_{i = 2}^{{n}_{max} - 2} {y}_{max} \left[i+2\right] - 2 ∗ {y}_{max} \left[i\right] + {y}_{max} \left[i-2\right]$ $K r ü mmung unten = {\sum }_{i = 2}^{{n}_{max} - 2} {y}_{min} \left[i+2\right] - 2 ∗ {y}_{min} \left[i\right] + {y}_{min} \left[i-2\right]$ $K r ü mmung rechts = {\sum }_{i = 2}^{{y}_{max} - 2} {n}_{max} \left[i+2\right] - 2 ∗ {n}_{max} \left[i\right] + {n}_{max} \left[i-2\right]$ $K r ü mmung links = {\sum }_{i = 2}^{{y}_{max} - 2} {n}_{min} \left[i+2\right] - 2 ∗ {n}_{min} \left[i\right] + {n}_{min} \left[i-2\right]$ können nun daraus die Krümmungswerte berechnet werden.

Beispielhaft ist in Figur 17A der Krümmungswert oben unter Anwendung der Formel Krümmung oben zu "-10" und der Krümmungswert rechts unter Anwendung der Formel Krümmung rechts zu "-1" berechnet worden.

Figur 17b zeigt eine beispielhafte Berechnungsmatrix 49 zur Berechnung der Krümmung unten und links einer Hüllkurve;

Der Index der untersten besetzten Zeile einer Spalte (kleinster TIM) ist in der darunter befindlichen Zeile ymin[n] dargestellt. In der Zeile -2ymin[n] ist der Wert aus der darüber liegenden Zeile ymin[n] jeweils mit dem Faktor -2 multipliziert worden. In der Zeile ymin [n-2] ist der Wert für das zwei Kästchen weiter links liegende Kästchen für ymin[n-2] eingetragen. In der Zeile ymin[n+2] ist der Wert für das zwei Kästchen weiter rechts liegende Kästchen ymin[n+2] eingetragen.

Analog dazu ist der Index der niedrigsten besetzten Spalte einer Zeile in der rechts daneben befindlichen Spalte nmin[y] dargestellt. In der Spalte -2nmin[y] sind diejenigen Werte eingetragen, die sich aus einer Multiplikation der Werte in der Spalte nmin[y] mit dem Faktor -2 ergeben. In der Spalte nmin[y-2] sind diejenigen Werte eingetragen, die sich in den jeweils zwei Kästchen darunter liegenden Kästchen befinden. In der Spalte nmin[y+2] sind diejenigen Werte eingetragen, die sich in den jeweils zwei Kästchen darüber liegenden Kästchen befinden.

Gemäß Fig 17B ist somit der Krümmungswert unten unter Anwendung der Formel Krümmung unten zu "0" und der Krümmungswert links unter Anwendung der Formel Krümmung links ebenfalls zu "0" berechnet worden.

Dies ist dem Fachmann anhand der hier gegebenen Informationen ohne Weiteres möglich.

Figur 18 zeigt eine Berechnungsmatrix 50 zur Berechnung der freien Ecken;

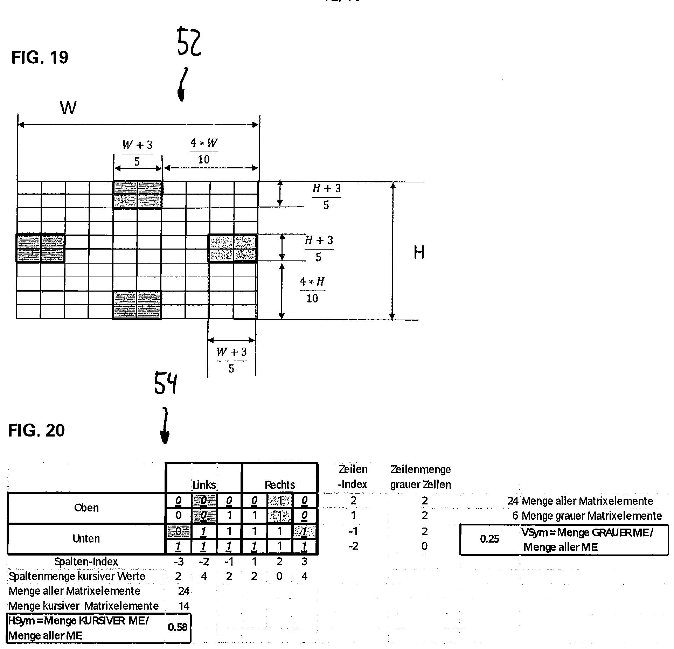

In den Figuren 18 und 19 sind exemplarische Umhüllungsrechtecke der Höhe H und der Breite W dargestellt, wobei zur Vereinfachung keines der Matrixfelder als gesetztes TIM dargestellt ist. Es wird davon ausgegangen, dass in diesen Umhüllungsrechtecken WxH jeweils eine Gruppe von TIMs vorhanden ist, die zuvor gemäß dem iterativen Gebietszuordnungsverfahren bestimmt worden ist. Ein Umhüllungsrechteck umhüllt eine Gruppe von TIMs und ist dabei so klein wie möglich, sodass alle TIMs dieser Gruppe darin liegen. Dementsprechend ist wenigstens ein TIM in der am weitesten links gelegenen Spalte, wenigstens ein TIM in der am weitesten rechts gelegenen Spalte, wenigstens ein TIM in der untersten Zeile und wenigstens ein TIM in der obersten Zeile des Umhüllungsrechtecks gelegen.

Gemäß der Berechnungsmatrix freie Ecken 50 werden die Eckbereiche des umhüllenden Rechtecks, das eine Höhe H und eine Breite W hat, betrachtet. Die Eckbereiche haben hier eine Höhe von (H+3)/5 und der Breite (W+3)/5, wobei das Ergebnis trunkiert wird. Selbstverständlich können die Abmessungen der freie Ecken auch anders bestimmt werden.

Wenn in jedem der Eckbereiche wenigstens ein TIM liegt, diese also nicht frei sind, bekommt die Formel FreeCorners den Wert Null, wenn in drei Eckbereichen wenigstens ein TIM liegt, ein Eckbereich jedoch ohne TIM ist, bekommt die Formel FreeCorners den Wert 1, usw.

Figur 19 zeigt eine Berechnungsmatrix 52 zur Berechnung von freien Ecken eines Umhüllungsvierecks.

Gemäß der Berechnungsmatrix freie Seitenmitten 52 werden unter den Seitenmitten diejenigen TIMs verstanden, die in einem Bereich der Höhe (H+3)/5 und der Breite (W+3)/5 liegen, der Seitenrand vom Seitenrand des umhüllenden Rechtecks um den Wert (4xW)/10 beabstandet ist (bei den Seitenmitten der Querseiten) und deren unterer Rand von dem unteren Rand des umhüllenden Rechtecks um den Wert (4xH)/ 10 beabstandet ist (bei den Seitenmitten der Querseiten). Selbstverständlich können die Abmessungen der Seitenmitten auch anders bestimmt werden.

Wenn in allen Vieren dieser Seitenmittenbereiche jeweils mindestens ein TIM liegt, bekommt die Formel FreeSides den Wert Null, wenn in drei dieser Seitenmitten jeweils ein TIM liegt, und in einem Seitenmittenbereich kein TIM ist, bekommt die Formel freie Seitenmitten/free corners den Wert 1, usw.

Figur 20 zeigt eine Berechnungsmatrix 54 zur Berechnung der Symmetrie.

In Fig. 20 ist eine Gruppe von TIMs beispielhaft in Form einer Berechnungsmatrix Symmetrie 54 dargestellt, die zuvor anhand des iterativen Gebietszuordnungs-Verfahren bestimmt worden ist.

Bei Fig. 20 handelt sich nicht um einen tatsächlichen Bereich der Teilentladungsmatrix 8, sondern um eine willkürlich erstellte Matrix, die zur einfacheren Erläuterung des Berechnungs-Prinzips erstellt wurde und entsprechend günstig besetzte Matrixelemente aufweist. Bei den "Einsen" dort handelt es sich nicht um Gebietsnummern, sondern um eine Kennung, dafür, ob ein Matrixelement besetzt ist ("Eins") und somit ein TIM ist oder nicht ("Null").

Das umhüllende Rechteck ist eine 6x4-Teilmatrix, und die Matrixfelder, die als TIM gesetzt worden sind, sind mit 1 gekennzeichnet, wohingegen die nicht als TIMs gesetzten Matrixfelder mit 0 gekennzeichnet sind.

Nun wird zeilenweise vorgegangen und für jede Zeile ein Abweichungswert bestimmt, der in Fig. 20 exemplarisch in eine zusätzliche Spalte ganz rechts eingetragen wird, und ebenso wird spaltenweise vorgegangen und für jede Spalte ein Abweichungswert bestimmt, der in Fig. 20 exemplarisch in eine zuunterst hinzugefügte Zeile eingetragen ist.

Diejenigen Matrixfelder, bei denen sich in der horizontalen Symmetrie, also bei einer Spiegelung um die vertikale Achse, die zwischen der dritten und vierten Spalte verläuft, eine Abweichung ergibt, sind grau hinterlegt.

Diejenigen Matrixfelder, bei denen sich bei einer vertikalen Symmetrie, also bei einer Spiegelung gegenüber der horizontalen Achse zwischen der zweiten und dritten Zeile, eine Abweichung ergibt, sind durch Kursivschrift und Unterstreichung des Matrixwerts gekennzeichnet.

Die Abweichung ergibt sich somit nach folgender Maßgabe.

Die Bedingungen für Markierung "grau" bzw. kursiv ergeben sich aus den folgenden Formeln: $grau = { \begin{matrix}ja , f \left[-Spaltenindex\right] \left[Zeilenindex\right] = = f \left[Spaltenindex\right] \left[Zeilenindex\right] \\ nein , f \left[-Spaltenindex\right] \left[Zeilenindex\right] ! = f \left[Spaltenindex\right] \left[Zeilenindex\right]\end{matrix}$ $Kursiv = { \begin{matrix}ja , f \left[Spaltenindex\right] \left[-Zeilenindex\right] = = f \left[Spaltenindex\right] \left[Zeilenindex\right] \\ nein , f \left[Spaltenindex\right] \left[-Zeilenindex\right] ! = f \left[Spaltenindex\right] \left[Zeilenindex\right]\end{matrix}$

Ein Matrixelement ist also dann "grau", wenn es den gleichen Wert hat wie sein Spiegelelement um die Vertikale Mittel-(Spiegel-)-Achse. Es ist dann "kursiv", wenn es den gleichen Wert hat, wie sein Spiegelelement um die horizontale Mittel-(Spiegel-)Achse

Die Symmetrien HSYM und VSYM ergeben sich dann angewendet auf die betrachtete Teilmatrix: $HSym = Menge der KURSIVEN Matrixelemente / Menge aller Matrixelemente$ Und $VSym = Menge der GRAUEN Matrixelemente / Menge aller Matrixelemente$

Zur Berechnung von HYSM und VSYM für ein tatsächliches Gebiet werden dann nur diejenigen Matrixelemente "grau" bzw. "kursiv" markiert und gezählt, die zum betrachteten Gebiet gehören. Die Menge aller Matrixelemente entspricht dabei dann der Menge der Matrixelemente des Umfassungsrechtecks.

In der unteren Zeile Spaltenindex ist der Index der jeweiligen Spalten eingetragen, der für die linken drei Spalten -3, -2 und -1 und die rechten drei Spalten 1, 2 und 3 beträgt, und in der rechten Spalte Zeilenindex ist der Index der jeweiligen Zeilen eingetragen, der für die unteren beiden Zeilen -2 und -1 und für die oberen beiden Zeilen 1 und 2 beträgt.

In der Zeile Spaltenmenge kursiver Werte ist die Menge der jeweils kursiv dargestellten Matrixelemente in dieser Spalte und in der Spalte Zeilenmenge graue Zellen ist die Menge der jeweils grauen Matrixelemente in der entsprechenden Zeile eingetragen. Die Menge der kursiven Matrixelemente ergibt sich aus einer Aufsummierung aller Werte in der Zeile Spaltenmenge kursiver Werte und die Menge aller grauen Matrixelemente ergibt sich aus einer Aufsummierung aller Werte in der Spalte Zeilenmenge grauer Zellen.

Unter Anwendung der Formeln für HSYM und VSYM ergibt sich der Wert 0,58 für die horizontale Symmetrie und der Wert 0,25 für die vertikale Symmetrie in dem vorliegenden Ausführungsbeispiel.

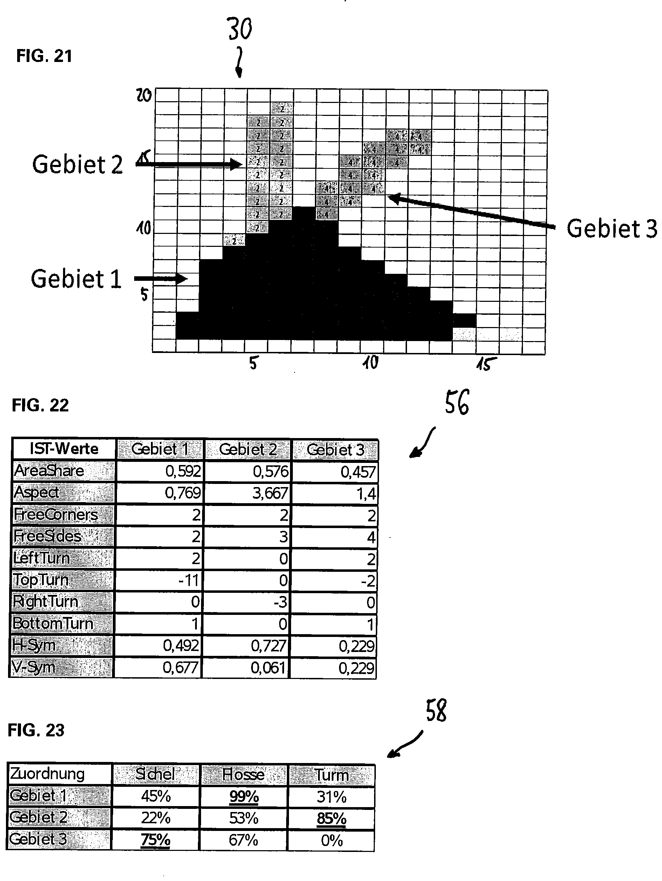

Figur 21 zeigt die Teilentladungsmatrix mit Gebietszuordnung 30 aus Figur 15a, in der die ermittelten und nachfolgend untersuchten Gebiete gesondert eingezeichnet sind.

Die Darstellung gemäß Fig. 21 entspricht der Darstellung der Teilentladungsmatrix mit Gebietszuordnung 30 gemäß Fig. 15a, wobei zur besseren Anschaulichkeit die drei identifizierten Gruppen von TIMs gesondert gekennzeichnet sind, nämlich die TIMs der Gruppe 1 als Gebiet 1, die TIMs der Gruppe 2 als Gebiet 2, und die TIMs der Gruppe 4 als Gebiet 3.

Diese Gebiete werden nun einer Formerkennung unterworfen. Die Erkennung der Formen läuft im Wesentlichen über die Analyse der entsprechenden Flächenanteile. Gemäß der folgenden Regelsätze wird überprüft, wo freie Bereiche liegen, also Bereiche, in denen keine TIMs gesetzt sind, wo besetzte Bereiche liegen, also Bereiche, in denen TIMs liegen, sowie welche Verhältnisse und Symmetrien auftreten. Für die charakteristischen Grundformen sind bestimmte Parameter dominierend, daher werden für die charakteristischen Grundformen nur diejenigen Parameter verwendet, die für sie tatsächlich benötigt werden.

Figur 22 zeigt eine Tabelle 56, in der für die drei untersuchten Gebiete die Istwerte für die Gebietsparameter eingetragen sind.

Für jedes der Gebiete 1, 2 und 3 werden nun die Gebietsparameter AreaShare, Aspect, FreeCorners, FreeSides, LeftTurn, TopTurn, RightTurn, BottomTurn, H-Sym und V-Sym berechnet, wobei das Prinzip dieser Berechnung vorstehend so detailliert erläutert worden ist, dass es für den Fachmann anhand der gegebenen Informationen ohne Weiteres nachvollziehbar ist.

Diese Gebietsparameter sind in der Tabelle Ist-Werte Gebietsparameter 56 gemäß Fig. 22 eingetragen.

Nun werden diese Gebietsparameter für jedes geschlossene Gebiet mit vorgegebenen Regelsätzen verglichen, um jedem Gebiet eine oder mehrere passende Grundformen zuzuordnen. Dabei werden für jedes Gebiet die vorhandenen Regelsätze angewendet. Dabei kann für jedes Gebiet die Wahrscheinlichkeit einer Übereinstimmung mit jedem der vorhandenen Regelsätze bestimmt werden.

Dabei kann jeder Regelsatz aus einer oder mehreren Teilregeln bestehen, die durch Logikoperatoren oder ggf. Klammern miteinander verknüpft sind.

Eine Teilregel ist der Vergleich eines einzelnen Gebietsparameters, wie sie in der Tabelle 56 enthalten sind, (Ist-Wert) mit einer Vorgabe (Sollwert). Das Ergebnis einer Teilregel wird einer Form zugewiesen, wobei für eine Form auch mehrere Regelsätze vorkommen können.

Als Vergleich stehen mindestens zur Verfügung:
"=" oder "!="
"=" ist das Prüfen auf Gleichheit, "!=" ist das Prüfen auf Ungleichheit. Mathematisch gilt "Wert Ungleichheit" = 1 - Wert Gleichheit" (Gleichheit berechnet nach der entsprechenden Formel F1 unten)
   ">" oder "<"
   - Kombination aus "=" und ">" bzw. "<"

Die Vergleiche können durch Abbildung stetiger Funktionen vorgenommen werden. Hierfür werden als Basisfunktionen einerseits die Gauß-Funktion $F 1 : = {e}^{- ln \left(ToleranzWert\right) {\left(\frac{IstWert - SollWert}{ToleranzBreite}\right)}^{2}}$ und andererseits die inversen Tangens-Funktionen $F 2 : = 0.5 + \frac{arctan \left(Normierung∗\left(Toleranzbreite-Abstand\right)\right)}{π}$ und $F 3 : = 0.5 - \frac{arctan \left(Normierung∗\left(Toleranzbreite+Abstand\right)\right)}{π}$ mit $Normierung = - \frac{tan \left(π∗\left(ToleranzWert-0.5\right)\right)}{ToleranzBreite}$ und $Abstand = Istwert - Sollwert$ wie folgt angewendet:
==":
   mit q = F1 und den Variablen:
   - IstWert = Eigenschaftswert aus zu bestimmender Form
   - SollWert = Wert der Eigenschaft der Referenzform
   - ToleranzBreite = 0,45
   - ToleranzWert = 50%
"!=":
   mit q =1- F1 und den Variablen:
   - IstWert = Eigenschaftswert aus zu bestimmender Form
   - SollWert = Wert der Eigenschaft der Referenzform
   - ToleranzBreite = 0,45
   - Toleranzwert = 50%
">":
   mit q = F2 und den Variablen:
   - IstWert = Eigenschaftswert aus zu bestimmender Form
   - SollWert = Wert der Eigenschaft der Referenzform
   - ToleranzBreite = 0,15
   - Toleranzwert = 15%
      - "<":
         mit q = F3 und den Variablen:
         - IstWert = Eigenschaftswert aus zu bestimmender Form
         - SollWert = Wert der Eigenschaft der Referenzform
         - ToleranzBreite = 0,15
         - Toleranzwert = 15%
      - "<=":
         mit $q = { \begin{matrix}F 1 , istwert > Sollwert \\ 1 , Istwert \leq Sollwert\end{matrix}$ und den Variablen
         - IstWert = Eigenschaftswert aus zu bestimmender Form
         - SollWert = Wert der Eigenschaft der Referenzform
         - ToleranzBreite = 0,45)
         - Toleranzwert = 50%
      - ">=":
         mit $q = { \begin{matrix}1 , istwert > Sollwert \\ F 1 , Istwert \leq Sollwert\end{matrix}$ und den Variablen
         - IstWert = Eigenschaftswert aus zu bestimmender Form
         - SollWert = Wert der Eigenschaft der Referenzform
         - ToleranzBreite = 0,45
         - Toleranzwert = 50%

Verknüpfungen können wie folgt durchgeführt werden.

"Und"-Verknüpfung erfolgt durch geometrische Mittelwertbildung $F 4 : = \sqrt[G]{Wert 1 ∗ Wert 2}$ mit $G = Gewicht 1 + Gewicht 2$

"Oder"-Verknüpfung erfolgt durch "Maximal"-Wertauswahl $F 5 : = { \begin{matrix}Wert 1 / Gewicht 1 , & Wert 1 \geq Wert 2 \\ Wert 2 / Gewicht 2 , & Wert 1 < Wert 2\end{matrix}$

Es gilt das Kommutativgesetz

Die Anwendung dieser Vergleichsfunktionen und dieser Verknüpfungen ist dem Fachmann anhand der hier gegebenen Informationen ohne Weiteres möglich.

Figur 23 zeigt eine Formenzuordnungs-Tabelle 58 für die untersuchten Gebiete.

Gemäß der Formenzuordnungs-Tabelle 58 ist für das Gebiet 1 eine 45%-ige Übereinstimmung mit dem Regelsatz Sichel, eine 99%-ige Übereinstimmung mit dem Regelsatz Flosse und ein 31%-ige Übereinstimmung mit dem Regelsatz Turm festgestellt worden. Für das Gebiet 2 ist eine 22%-ige Übereinstimmung mit dem Regelsatz Sichel, eine 44%-ige Übereinstimmung mit dem Regelsatz Flosse und eine 85%-ige Übereinstimmung mit dem Regelsatz Turm festgestellt worden. Für das Gebiet 3 ist eine 75%-ige Übereinstimmung mit dem Regelsatz Sichel, eine 67%-ige Übereinstimmung mit dem Regelsatz Flosse und eine 0%-ige Übereinstimmung mit dem Regelsatz Turm festgestellt worden.

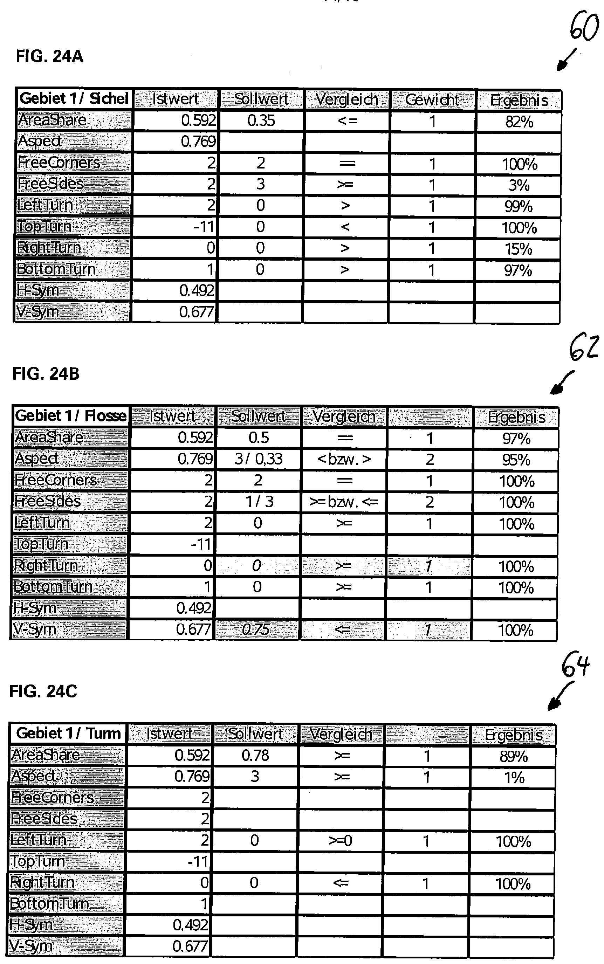

Figur 24A zeigt eine Tabelle 60 zur Bestimmung des Wahrscheinlichkeitswerts der Übereinstimmung des Gebiets 1 mit dem Regelsatz Sichel;

Figur 24B zeigt eine Tabelle 62 zur Berechnung des Wahrscheinlichkeitswerts der Übereinstimmung des Gebiets 1 mit dem Regelsatz Flosse, und

Figur 24C zeigt eine Tabelle 64 zur Berechnung des Wahrscheinlichkeitswerts der Übereinstimmung des Gebiets 1 mit dem Regelsatz Turm.

Die Anwendung des Regelsatzes Sichel, Flosse und Turm auf das Gebiet 1, also die Berechnung der Wahrscheinlichkeitswerte 45% der Übereinstimmung mit dem Regelsatz Sichel, 99% der Übereinstimmung mit dem Regelsatz Flosse und 31% der Übereinstimmung mit dem Regelsatz Turm, ist wie folgt exemplarisch beschrieben.

Bei der Berechnung des Wahrscheinlichkeitswerts der Übereinstimmung des Gebiets 1 mit dem Regelsatz Sichel wird wie folgt vorgegangen.

Es werden die Wahrscheinlichkeitswerte für die Übereinstimmung der Ist-Werte Flächenanteil, freie Ecken, freie Seiten, Krümmung links, Krümmung rechts, Krümmung rechts und Krümmung oben mit den entsprechenden Soll-Werten des Regelsatzes bestimmt, wie in Figur 24A eingetragen.

Somit ergibt sich als Ergebnis: $Ergebnis = \sqrt[7]{82 % ∗ 100 % ∗ 3 % ∗ 99 % ∗ 100 % ∗ 15 % ∗ 97 %} = 45 %$

Dies entspricht einer 45%-igen Wahrscheinlichkeit der Übereinstimmung des Gebiets 1 mit dem Regelsatz Sichel. Dieser Ergebniswert wird für das Gebiet 1 in die Formenzuordnungs-Tabelle 58 eingetragen.

Die Teilergebnisse ergeben sich aus der Anwendung der Regel und der entsprechenden Formel für den Vergleich mit den entsprechenden Ist- und Soll-Werten.

Z.B. wurde das Ergebnis für den Flächenanteil mit 82% festgestellt. Bei Einsetzen des Sollwertes (35%) und des Ist-Wertes (59,2%) in die zur Berechnung von "<=" zu verwendende Formel F1 (Fl da Istwert > Sollwert) ergibt sich als Ergebnis 82%. (s. Zeile 1 "AreaShare" der obigen Tabelle).

Für die weiteren Zeilen wird ebenso verfahren. Aus den Ergebnissen in der letzten Spalte gemäß Figur 24A wird nun ein Mittelwert gebildet. Dafür wird die siebte Wurzel (da die Summe der Gewichte der sieben Vergleiche sieben ergibt) aus dem Produktergebnis gezogen und als Wahrscheinlichkeit 58 in Tabelle 23 eingetragen. Dieses Prinzip des Multiplizierens/Wurzelziehens ist allgemein auch als geometrische Mittelwertbildung bekannt.

Bei der Berechnung des Wahrscheinlichkeitswerts der Übereinstimmung des Gebiets 1 mit dem Regelsatz Flosse wird wie folgt vorgegangen.

Es werden die Wahrscheinlichkeitswerte für die Übereinstimmung der Ist-Werte Flächenanteil, Seitenverhältnis, freie Ecken, freie Seitenmitten, Krümmung unten, Krümmung links, Krümmung rechts und Krümmung oben mit den entsprechenden Soll-Werten des Regelsatzes Flosse wie in Figur 24B eingetragen bestimmt:
Somit ergibt sich als Ergebnis: $Ergebnis = \sqrt[9]{97 % ∗ 95 {%}^{2} ∗ 100 % ∗ 100 {%}^{2} ∗ 100 % ∗ 100 % ∗ 100 %} = 99 %$

Dies entspricht einer 99%-igen Wahrscheinlichkeit der Übereinstimmung des Gebiets 1 mit dem Regelsatz Flosse. Dieser Ergebniswert wird für das Gebiet 1 in die Formenzuordnungs-Tabelle 58 eingetragen.

Bei der Berechnung des Wahrscheinlichkeitswerts der Übereinstimmung des Gebiets 1 mit dem Regelsatz Turm wird wie folgt vorgegangen.

Es werden die Wahrscheinlichkeitswerte für die Übereinstimmung der Ist-Werte Flächenanteil, Seitenverhältnis, Krümmung links und Krümmung rechts mit den entsprechenden Soll-Werten des Regelsatzes Turm bestimmt, wie in Fig. 24C eingetragen

Somit ergibt sich als Ergebnis: $Ergebnis = \sqrt[4]{89 % ∗ 1 % ∗ 100 % ∗ 100 %} = 31 %$

Dies entspricht einer 31%-igen Wahrscheinlichkeit der Übereinstimmung des Gebiets 1 mit dem Regelsatz Turm. Dieser Ergebniswert wird für das Gebiet 1 in die Formenzuordnungs-Tabelle 58 eingetragen.

Für die anderen Gebiete 2 und 3 erfolgt die Berechnung der Wahrscheinlichkeit der Übereinstimmung dieser Gebiete mit den Regelsätzen Sichel, Flosse und Turm analog.

Nun wird jedem Gebiet diejenige Form zugeordnet, die das beste Ergebnis, also die größte Übereinstimmung in Prozent ausweist. Dementsprechend wird dem Gebiet 1 die Grundform Flosse, dem Gebiet 2 die Grundform Turm und dem Gebiet 3 die Grundform Sichel zugeordnet.

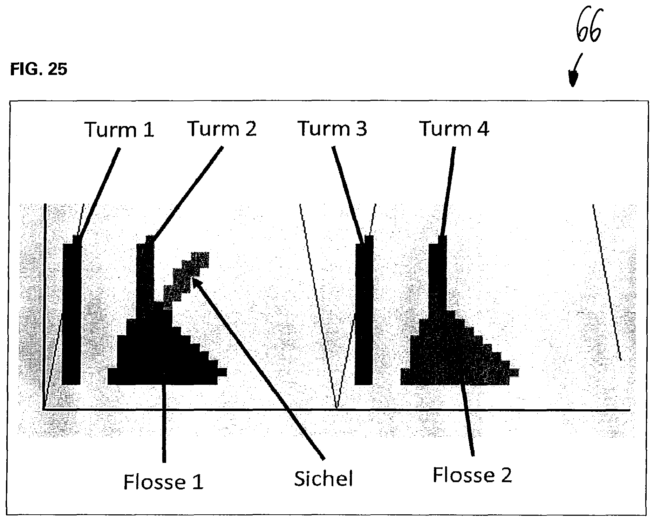

Figur 25 zeigt die komplette Ausgangs-Teilentladungsmatrix mit Formenzuordnung zu den Gebieten 66.

Gemäß der kompletten Ausgangs-Teilentladungsmatrix mit Formenzuordnung 66 ist den Gruppen von TIMs mit vertikaler Balkenform bei Phasenlage 20°, 60°, 200° und 240° jeweils die Grundform Turm zugeordnet worden. Diese Gruppen von TIMs sind in Fig. 25 als Turm 1 bis Turm 4 bezeichnet.

Der Gruppe von TIMs von Phasenlage 50 bis 120° und 230 bis 300° Phasenlage, die grob gesprochen die Grundform eines Dreiecks aufweisen, ist jeweils die Grundform Flosse zugeordnet worden. Diese Gruppen von TIMs sind in Fig. 25 mit Flosse 1 und Flosse 2 bezeichnet.

Der Gruppe von TIMs, die sich bei Phasenlage 80 bis 100° von der Spitze der Grundform Flosse 1 schräg nach rechts oben erstreckt, ist die Grundform Sichel zugeordnet worden, und diese Gruppe von TIMs ist in Fig. 25 mit der Bezeichnung Sichel versehen worden.

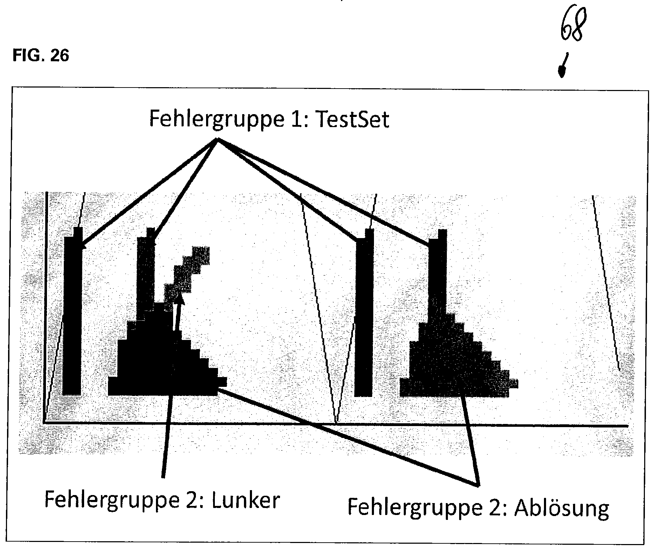

Figur 26 zeigt die komplette Ausgangs-Teilentladungsmatrix mit Zuordnung der jeweils ursächlichen Teilentladungs-Quellen zu den Gebieten 68.

Die erkannten und in Fig. 25 bezeichneten Grundformen werden nun nach bekannten Fehlerregeln, die charakteristische Teilentladungs-Impuls-Gebiets-GrundformTeilentladungs-Impuls-Gebiets-Grundformen und charakteristische Kombinationen aus Teilentladungsimpulsgrundformen bekannten Teilentladungsquellen zuordnen, bekannten Teilentladungsquellen zugeordnet.

Gemäß einer Fehlerregel werden geschlossene Gebiete, die eine gleiche Grundform aufweisen und zueinander um 180° verschoben sind, einander zugeordnet, und zwar nach der folgenden Formel. $Zugehörig : = GleicheForm = = WAHR & & Phasenverschiebung = = 180 °$

Gemäß der kompletten Ausgangsteilentladungsmatrix mit Gebietszuordnung 60 trifft dies für die Grundformen Turm 1 und Turm 3, für die Grundformen Turm 2 und Turm 4 und für die Grundformen Flosse 1 und Flosse 2 zu. Dementsprechend werden die Grundformen Turm 1 und Turm 3 als einander zugehörig zugeordnet, die Grundformen Turm 2 und Turm 4 werden als einander zugehörig zugeordnet und die Grundformen Flosse 1 und Flosse 2 werden als einander zugehörig zugeordnet.

Gemäß einer weiteren Fehlerregel ist das Störsignal eines HS-Testset dadurch gekennzeichnet, dass zwei Paare der Grundform Turm vorhanden sind, von denen das erste Paar voneinander um die Phasenlage von 180° getrennt ist, von denen das zweite Paar ebenfalls um 180° zueinander getrennt ist und wobei das zweite Paar um etwa 45° Phasenlage zu dem ersten Paar verschoben ist. Die entsprechende Fehlerregel lautet wie folgt: $Match : = FormA = = Pole & & FormB = = Pole & & PhaseOffSet = = 45$

Gemäß einer weiteren Fehlerregel ist als Teilentladungsquelle dann ein Testset anzunehmen, wenn genau vier Grundformen Turm vorhanden sind, wenn also die folgende Formel erfüllt ist: $TestSet : = AnzahlGebiete = = 4 & & Anzahl Türme = = 4$

Die Formeln zum Zusammenführen mehrerer Gebieten zu Gebietsgruppen gilt dann als erfüllt, wenn das Formelergebnis größer als "0,7" ist.

Gemäß einer weiteren Fehlerregel ist eine Teilentladungs-Impuls-Gebiets-GrundformTeilentladungs-Impuls-Gebiets-Grundform dann der Teilentladungsquelle Lunker zuzuordnen, wenn es sich um eine Gruppe aus einem einzelnen Gebiet der Grundform Sichel handelt und sich dieses weder im Maximum noch im Nulldurchgang der Prüfspannung befindet, wenn also die folgende Formel im Vergleich mit allen anderen Fehlerregeln die größte Wahrscheinlichkeit ergibt: $Lunker : = Anzahl Gebiete = = 1 & & AnzahlSichel = = 1 & & NäheMaximum = = FALSCH & & NäheNulldurchgang = = FALSCH$

Gemäß einer weiteren Fehlerregel ist die Teilentladungsquelle Ablösung dann vorhanden, wenn zwei Grundformen Flosse vorhanden sind, die voneinander um die Phasenlage von 180° getrennt sind und die sich zudem weder im Maximum noch im Nulldurchgang befinden, wenn also die folgende Formel im Vergleich mit allen anderen Fehlerregeln die größte Wahrscheinlichkeit ergibt: $Ablösung = = AnzahlGebiete = = 2 & & AnzahlFlossen = = 2 & & NäheMaximum = = FALSCH & & NäheNulldurchgang = = FALSCH$

Weitere häufig vorkommende Fehlerarten sind beispielweise noch Spitzen: $Spitze : = AnzahlGebiete = = 1 & & AnzahlSpot = = 1 & & NäheMaximum = = Wahr$

Oder freie Partikel $Partikel : = Anzahl Gebiete = = 2 & & AnzahlHügel = = 2 & & NäheMaximum = = Wahr$

Dabei kann die Nähe des Maximums bzw. die Nähe des Nulldurchgangs wie folgt berechnet worden. $Nähe Maximum : = Phasenwinkel des Flächenschwerpunkt zum nächsten Nulldurchgang / 180 °$ $Nähe Nulldurchgang : = \left(Phasenwinkel des Flächenschwerpunkt zum nächsten Nulldurchgang+90°\right) / 90 °$

Grundsätzlich wird die Übereinstimmung der Grundformen mit diesen Fehlerregeln überprüft. Dabei kann auch hier das Ergebnis ein Wahrscheinlichkeitswert sein, der die Wahrscheinlichkeit der Übereinstimmung einer oder mehrerer Grundformen mit der jeweils betrachteten Fehlerregel angibt.

Im vorliegenden Ausführungsbeispiel sind die vier Grundformen Turm 1 bis Turm 4 bei den Phasenlagen 20, 60, 200 und 240° bei Anwendung der Fehlerregel Testset der Teilentladungsquelle Testset zugeordnet worden, die Grundformen Flosse 1 und Flosse 2 sind bei Anwendung der Fehlerregel Ablösung der Teilentladungsquelle Ablösung zugeordnet worden, und die Grundform Sichel ist bei Anwendung der Fehlerregel Lunker der Teilentladungsquelle Lunker zugeordnet worden.

Als Ergebnis des Verfahrens zum Erkennen einer oder mehrerer gleichzeitig auftretender Teilentladungsquellen aus Teilentladungsmessdaten gemäß des vorliegend beschriebenen Ausführungsbeispiels steht nun fest, dass die Teilentladungsmesssignale, welche die Grundlage für die komplette Ausgangsteilentladungsmatrix 6 aus Fig. 2 bilden und aus denen die komplette Ausgangsteilentladungsmatrix 6 erstellt worden ist, charakteristisch sind für die Teilentladungsquellen Testset, Lunker und Ablösung. Mit anderen Worten: in der gasisolierten Anlage ist ein Testset, ein Lunker und eine Ablösung vorhanden, welche die unerwünschten Teilentladungen verursachen und zu Problemen führen können.

Durch dieses Ergebnis können das Testset als Störsignal gefiltert werden, und der Lunker sowie die Ablösung in der gasisolierten Anlage entfernt oder korrigiert werden, um Problemen oder Schäden vorzubeugen.

### Bezugszeichenliste

2 Auszug einer Teilentladungsmessung
4 Teilentladungsmatrix
6 komplette Ausgangs-Teilentladungsmatrix
8 Teilentladungsmatrix
10 Abfrage-Reihenfolge
12 Struktogramm iteratives Gebietszuordnungsverfahren
14 Berechnungs-Teilmatrix Diagonalaspekt
16 Berechnungs-Teilmatrix Kreuzaspekt
18 Berechnungs-Teilmatrix Diagonalaspekt benachbarte Felder
20 Berechnungs-Teilmatrix Kreuzaspekt benachbarte Felder
22 Teilmatrix Abweichungswert
24 Teilmatrix Gebietsnummer am Anfang
26 Teilmatrix Gebietsnummer nach erstem Zuordnungsschritt
30 Teilentladungsmatrix mit Gebietszuordnung
32 komplette Ausgangs-Teilentladungsmatrix mit Gebietszuordnung
34 Grundform Punkt
36 Grundform Hügel
38 Grundform Flamme
40 Grundform Turm
42 Grundform Sichel
44 Grundform Flosse
46 Grundform Ebene
48 Berechungsmatrix Hüllkurve
50 Berechungsmatrix freien Ecken
52 Berechungsmatrix freie Seitenmitten
54 Berechungsmatrix Symmetrie
56 Tabelle Ist-Werte Gebietsparameter
58 Tabelle Formzuordnung Gebiete
60 Tabelle zur Bestimmung des Wahrscheinlichkeitswerts der Übereinstimmung des Gebiets 1 mit dem Regelsatz Sichel
62 Tabelle zur Berechnung des Wahrscheinlichkeitswerts der Übereinstimmung des Gebiets 1 mit dem Regelsatz Flosse
64 Tabelle zur Berechnung des Wahrscheinlichkeitswerts der Übereinstimmung des Gebiets 1 mit dem Regelsatz Turm
66 komplette Ausgangs-Teilentladungsmatrix mit Gebietszuordnung
68 komplette Ausgangs-Teilentladungsmatrix mit Zuordnung der ursächlichen Teilentladungs-Quellen

## Patentansprüche

1. Verfahren zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel, aufweisend die folgenden Schritte:
ausgehend von einer Häufigkeits-Matrix (4), in die gemessene Teilentladungs-Impulse als Teilentladungs-Impuls-Matrixfelder nach erfasster Impuls-Amplitude und nach erfasster Phasenlage eingetragen sind und in der Teilentladungs-Impuls-Matrixfelder zu wenigstens einem geschlossenen Gebiet von Teilentladungs-Impuls-Matrixfeldern zugeordnet sind;
Bestimmen von Gebietsparametern des wenigstens einen geschlossenen Gebiets von Teilentladungs-Impuls-Matrixfeldern;
Vergleichen, für jedes geschlossene Gebiet von Teilentladungs-Impuls-Matrixfeldern, von Gebietsparametern des geschlossenen Gebiets von Teilentladungs-Impuls-Matrixfeldern mit vorgegebenen Regelsätzen, wobei jeder Regelsatz einer charakteristischen Teilentladungs-Impuls-Gebiets-Grundform (34-46) entspricht, und
Zuordnen, für jedes geschlossene Gebiet von Teilentladungs-Impuls-Matrixfeldern, desjenigen Regelsatzes zu dem geschlossenen Gebiet, der dem geschlossenen Gebiet am besten entspricht, sodass jedem geschlossenen Gebiet von Teilentladungs-Impuls-Matrixfeldern eine Teilentladungs-Impuls-Gebiets-Grundform (34-46) zugeordnet wird;
Anwenden von vorgegebenen Fehlerregeln, die charakteristische Teilentladungs-Impuls-Gebiets-Grundformen (34-46) und charakteristische Kombinationen aus Teilentladungs-Impuls-Gebiets-Grundformen (34-46) bekannten Teilentladungs-Quellen zuordnen, auf die ermittelten Teilentladungs-Impuls-Gebiets-Grundformen (34-46), um diejenigen Teilentladungs-Quellen zu bestimmen, welche die entsprechenden Teilentladungs-Impulse abgegeben haben;
**dadurch gekennzeichnet, dass**
die Teilentladungs-Impuls-Matrixfelder in der Häufigkeits-Matrix anhand ihrer Kettenlängen zu wenigstens einem geschlossenen Gebiet von Teilentladungs-Impuls-Matrixfeldern zugeordnet werden;
beim Zuordnen der Teilentladungs-Impuls-Matrixfelder in der Häufigkeits-Matrix zu wenigstens einem geschlossenen Gebiet von Teilentladungs-Impuls-Matrixfeldern zunächst für jedes Teilentladungs-Impuls-Matrixfeld die Eigenschaften Länge zusammenhängender Teilentladungs-Impuls-Matrixfelder in horizontaler Richtung, Länge zusammenhängender Teilentladungs-Impuls-Matrixfelder in vertikaler Richtung, Länge zusammenhängender Teilentladungs-Impuls-Matrixfelder in diagonal steigender Richtung und Länge zusammenhängender Teilentladungs-Impuls-Matrixfelder in diagonal fallender Richtung zugeordnet werden, und
beim Zuordnen der Teilentladungs-Impuls-Matrixfelder in der Häufigkeits-Matrix zu wenigstens einem geschlossenen Gebiet von Teilentladungs-Impuls-Matrixfeldern für jedes Teilentladungs-Impuls-Matrixfeld die Eigenschaft Länge zusammenhängender Teilentladungs-Impuls-Matrixfelder in horizontaler Richtung mit der Eigenschaft Länge zusammenhängender Teilentladungs-Impuls-Matrixfelder in vertikaler Richtung ins Verhältnis gesetzt wird, um die abgeleitete Eigenschaft Kreuz-Aspekt zu bestimmen, und/oder für jedes Teilentladungs-Impuls-Matrixfeld die Eigenschaft Länge zusammenhängender Teilentladungs-Impuls-Matrixfelder in diagonal steigender Richtung mit der Eigenschaft Länge zusammenhängender Teilentladungs-Impuls-Matrixfelder in diagonal fallender Richtung ins Verhältnis gesetzt wird, um die abgeleitete Eigenschaft Diagonal-Aspekt zu bestimmen.

2. Verfahren nach Anspruch 1, wobei eine Häufigkeits-Matrix, in die gemessene Teilentladungs-Impulse als Teilentladungs-Impuls-Matrixfelder nach erfasster Impuls-Amplitude und nach erfasster Phasenlage eingetragen werden, zunächst gebildet wird, und/oder wobei in der Häufigkeits-Matrix Teilentladungs-Impuls-Matrixfelder zu wenigstens einem geschlossenen Gebiet von Teilentladungs-Impuls-Matrixfeldern zugeordnet werden.

3. Verfahren nach Anspruch 1, wobei beim Zuordnen der Teilentladungs-Impuls-Matrixfelder in der Häufigkeits-Matrix zu wenigstens einem geschlossenen Gebiet von Teilentladungs-Impuls-Matrixfeldern die Eigenschaften Kreuz-Aspekt und Diagonal-Aspekt für jeweils nebeneinanderliegende Teilentladungs-Impuls-Matrixfelder herangezogen werden, um zu entscheiden, ob jeweils nebeneinanderliegende Teilentladungs-Impuls-Matrixfelder zu demselben geschlossenen Gebiet gehören oder nicht.

4. Verfahren nach Anspruch 1 oder 3, wobei beim Zuordnen der Teilentladungs-Impuls-Matrixfelder in der Häufigkeits-Matrix zu wenigstens einem geschlossenen Gebiet von Teilentladungs-Impuls-Matrixfeldern für alle Teilentladungs-Impuls-Matrixfelder paarweise die Abweichung eines Teilentladungs-Impuls-Matrixfelds zu den jeweils horizontal, vertikal und diagonal benachbarten Teilentladungs-Impuls-Matrixfeldern bestimmt wird, wobei für diese Bestimmung der Ähnlichkeit die abgeleiteten Eigenschaften Kreuz-Aspekt und Diagonal-Aspekt herangezogen werden.

5. Verfahren nach Anspruch 3 oder 4, wobei beim Zuordnen der Teilentladungs-Impuls-Matrixfelder in der Häufigkeits-Matrix zu wenigstens einem geschlossenen Gebiet von Teilentladungs-Impuls-Matrixfeldern für jedes Teilentladungs-Impuls-Matrixfeld die Kreuzabweichung nach der folgenden Formel $KreuzAbweichung = abs \left(\frac{Minimum \left(KreuzAspekt Punkt,KreuzAspekt NachbarPunkt\right)}{Maximum \left(KreuzAspekt Punkt,KreuzAspekt NachbarPunkt\right)}-1\right) ,$ wobei abs für den Absolutwert steht, Minimum (KreuzAspekt Punkt, KreuzAspekt Nachbarpunkt) für das Minimum aus dem KreuzAspekt-Wert des Teilentladungs-Impuls-Matrixfelds und dem KreuzAspekt-Wert des jeweils betrachteten horizontal, vertikal und diagonal benachbarten Teilentladungs-Impuls-Matrixfelds steht, und Maximum (KreuzAspekt Punkt, KreuzAspekt Nachbarpunkt) für das Maximum aus dem KreuzAspekt-Wert des Teilentladungs-Impuls-Matrixfelds und dem KreuzAspekt-Wert des jeweils betrachteten horizontal, vertikal und diagonal benachbarten Teilentladungs-Impuls-Matrixfelds steht,
die Diagonalabweichung nach der folgenden Formel $DiagonalAbweichung = abs \left(\frac{Minimum \left(DiagonalAspekt Punkt,DiagonalAspekt NachbarPunkt\right)}{Maximum \left(DiagonalAspekt Punkt,DiagonalAspekt NachbarPunkt\right)}-1\right) ,$ wobei abs für den Absolutwert steht, Minimum (DiagonalAspekt Punkt, DiagonalAspekt Nachbarpunkt) für das Minimum aus dem DiagonalAspekt-Wert des Teilentladungs-Impuls-Matrixfelds und dem DiagonalAspekt-Wert des jeweils betrachteten horizontal, vertikal und diagonal benachbarten Teilentladungs-Impuls-Matrixfelds steht, und Maximum (DiagonalAspekt Punkt, DiagonalAspekt Nachbarpunkt) für das Maximum aus dem DiagonalAspekt-Wert des Teilentladungs-Impuls-Matrixfelds und dem DiagonalAspekt-Wert des jeweils betrachteten horizontal, vertikal und diagonal benachbarten Teilentladungs-Impuls-Matrixfelds steht,
und die Abweichung zwischen Kreuzabweichung und Diagonalabweichung nach der folgenden Formel $Abweichung = max \left(Kreuzabweichung, Diagonaabweichung\right)$ bestimmt werden, und wobei insbesondere beim Zuordnen der Teilentladungs-Impuls-Matrixfelder in der Häufigkeits-Matrix zu wenigstens einem geschlossenen Gebiet von Teilentladungs-Impuls-Matrixfeldern für jedes Teilentladungs-Impuls-Matrixfeld dasjenige horizontal, vertikal oder diagonal benachbarte Teilentladungs-Impuls-Matrixfeld bestimmt wird, das die größte noch erlaubte Abweichung unterhalb einer vorgegebenen Maximalabweichung aufweist, und wobei insbesondere das Zuordnen der Teilentladungs-Impuls-Matrixfelder in der Häufigkeits-Matrix zu wenigstens einem geschlossenen Gebiet von Teilentladungs-Impuls-Matrixfeldern dadurch erfolgt, dass nacheinander für jedes Teilentladungs-Impuls-Matrixfeld das Teilentladungs-Impuls-Matrixfeld und das horizontal, vertikal oder diagonal benachbarte Teilentladungs-Impuls-Matrixfeld mit der größten noch erlaubten Abweichung unterhalb einer vorgegebenen Maximalabweichung betrachtet werden, und dem Teilentladungs-Impuls-Matrixfeld eine neue Gebietsnummer zugeordnet wird, wenn beide Teilentladungs-Impuls-Matrixfelder noch keine Gebietsnummer haben, dem Teilentladungs-Impuls-Matrixfeld die Gebietsnummer des Nachbar-Teilentladungs-Impuls-Matrixfelds zugeordnet wird, wenn die Gebietsnummer des Nachbar-Teilentladungs-Impuls-Matrixfelds größer ist als die Gebietsnummer des Teilentladungs-Impuls-Matrixfelds, und wenn keine der zwei Bedingungen erfüllt ist, die Gebietsnummer des Teilentladungs-Impuls-Matrixfelds beibehalten wird, und mit der Zuordnung für das nächste Teilentladungs-Impuls-Matrixfeld fortgefahren wird, und wobei insbesondere diese Zuordnung solange iterativ auf alle Teilentladungs-Impuls-Matrixfelder angewendet wird, bis sich keine Änderung von Gebietsnummern mehr ergibt, und wobei insbesondere beim Zuordnen der Teilentladungs-Impuls-Matrixfelder in der Häufigkeitsmatrix zu wenigstens einem geschlossenen Gebiet von Teilentladungs-Impuls-Matrixfeldern diejenigen Matrixfelder, die keine Teilentladungs-Impuls-Matrixfelder sind, nicht betrachtet werden, und wobei insbesondere die Zuordnung für ein Teilentladungs-Impuls-Matrixfeld nur dann vorgenommen wird, wenn die Abweichung für das jeweils betrachtete Teilentladungs-Impuls-Matrixfeld kleiner ist als ein vorgegebener Maximalabweichungswert, der in einem Bereich von 0,6 bis 0,8 liegt und vorzugsweise etwa 0,7 ist, und ansonsten mit der Zuordnung für das nächste Teilentladungs-Impuls-Matrixfeld fortgefahren wird.

6. Verfahren nach einem der vorhergehenden Ansprüche, wobei beim Zuordnen der Teilentladungs-Impuls-Matrixfelder in der Häufigkeits-Matrix zu wenigstens einem geschlossenen Gebiet von Teilentladungs-Impuls-Matrixfeldern alle Teilentladungs-Impuls-Matrixfelder entfernt werden, deren Gebiet zu klein ist, wobei ein Gebiet insbesondere dann zu klein ist, wenn es weniger als 10 Teilentladungs-Impuls-Matrixfelder umfasst und/oder wenn dessen horizontale oder vertikale Ausdehnung kleiner ist als 8 Teilentladungs-Impuls-Matrixfelder.

7. Verfahren nach einem der vorhergehenden Ansprüche, wobei es sich bei den Gebietsparametern des wenigstens einen geschlossenen Gebiets von Teilentladungs-Impuls-Matrixfeldern um wenigstens einen Gebietsparameter aus der folgenden Gruppe handelt: Bedeckungsgrad = Anzahl der Teilentladungs-Impuls-Matrixfelder im umhüllenden Rechteck / Anzahl aller Matrixfelder im umhüllenden Rechteck; Seitenverhältnis des umhüllenden Rechtecks = vertikale Ausdehnung / horizontale Ausdehnung des umhüllenden Rechtecks; freie Ecken des umhüllenden Rechtecks = Ecken des umhüllenden Rechtecks, an denen alle Matrixfelder frei sind; freie Seitenmitten des umhüllenden Rechtecks = Seitenmitten des umhüllenden Rechtecks, an denen alle Matrixfelder frei sind; Krümmung nach links; Krümmung nach rechts; Krümmung oben; Krümmung unten; vertikale Symmetrie = Symmetrie um die vertikale Mittenachse; und horizontale Symmetrie = Symmetrie um die horizontale Mittenachse.

8. Verfahren nach einem der vorhergehenden Ansprüche, wobei es sich bei den Teilentladungs-Impuls-Gebiets-Grundformen (34-46) um wenigstens eine der Grundformen aus der folgenden Gruppe handelt: Punkt; Hügel; Flamme; Turm; Sichel; Flosse; Ebene.

9. Verfahren nach einem der vorhergehenden Ansprüche, wobei bei dem Schritt des Vergleichens, für jedes geschlossene Gebiet von Teilentladungs-Impuls-Matrixfeldern, von Gebietsparametern des geschlossenen Gebiets von Teilentladungs-Impuls-Matrixfeldern mit vorgegebenen Regelsätzen, jedem geschlossenen Gebiet ein Wahrscheinlichkeitswert zugeordnet wird, der der Wahrscheinlichkeit der Übereinstimmung des geschlossenen Gebiets mit der Teilentladungs-Impuls-Gebiets-Grundform (34-46) eines charakteristischen Teilentladungs-Quellensignals entspricht, und wobei insbesondere die Wahrscheinlichkeit der Übereinstimmung von IST- mit dem SOLL-Wert durch eine stetige Funktion berechnet wird, und wobei insbesondere als stetige Funktion wenigstens eine der Funktionen $F 1 : = {e}^{- ln \left(ToleranzWert\right) {\left(\frac{IstWert - SollWert}{ToleranzBreite}\right)}^{2}}$ $F 2 : = 0.5 + arctan \left(Normierung∗\left(Verschiebung-IstWert\right)\right)$ $F 3 : = 0.5 - arctan \left(Normierung∗\left(Verschiebung+IstWert\right)\right)$ verwendet wird, und wobei bei dem Schritt des Zuordnens dem geschlossenen Gebiet derjenige Regelsatz zugeordnet wird, der den höchsten Wahrscheinlichkeitswert der Übereinstimmung aufweist.

10. Verfahren nach einem der vorhergehenden Ansprüche, wobei es sich bei den Fehlerregeln um wenigstens eine Fehlerregel aus der folgenden Gruppe handelt: Fehlerregel für einen Testset, Fehlerregel für eine Ablösung, Fehlerregel für einen Lunker, Fehlerregel für eine Gleitentladung, Fehlerregel für einen Partikel, Fehlerregel für eine Spitze, Fehlerregel für ein freies Potential, Fehlerregel für einen Riß, Fehlerregel für ein Mobiltelefon, Fehlerregel für ein Radarsignal, Fehlerregel für ein Verstärkerrauschen, Fehlerregel für ein zu großes Eingangssignal, Fehlerregel für ein Thyristor-Signal..

11. Verfahren nach einem der vorhergehenden Ansprüche, wobei die Fehlerregeln bei bestimmten Phasenlagen auftretende Teilentladungs-Impuls-Gebiets-Grundformen (34-46) bekannten Teilentladungsquellen zuordnen und bei bestimmten Phasenlagen auftretende, zueinander um eine bestimmte Phasenverschiebung beabstandete Grundformen bekannten, ursächlichen Teilentladungsquellen zuordnen.

12. Verfahren nach einem der vorhergehenden Ansprüche, wobei die Teilentladungs-Messsignale der mit einer Wechselspannung beaufschlagten elektrischen Vorrichtung mit einem Teilentladungs-Sensor/Teilentladungs-Messgerät erfasst werden.

13. Teilentladungs-Messgerät, das zur Erfassung von Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel ausgebildet ist, und das dazu eingerichtet ist, ein Verfahren zum Erkennen einer oder mehrerer gleichzeitig auftretender Teilentladungsquellen gemäß einem der vorhergehenden Ansprüche basierend auf den erfassten Teilentladungs-Messsignalen auszuführen.

14. Computerprogramm mit Programminstruktionen zur Ausführung eines Verfahrens zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel, das so ausgebildet ist, dass ein Verfahren nach einem der vorhergehenden Ansprüche basierend auf erfassten Teilentladungs-Messsignalen durchführbar ist.

15. Computersystem oder Datenträger mit einem Computerprogramm zur Ausführung eines Verfahrens nach einem der vorhergehenden Ansprüche zum Erkennen einer oder mehrerer gleichzeitig auftretender Teilentladungs-Quellen aus Teilentladungs-Messsignalen einer mit einer Wechselspannung beaufschlagten elektrischen Vorrichtung, insbesondere einer gasisolierten Anlage, einem Hochspannungsgenerator, einem Transformator, einer elektrischen Hochspannungsleitung oder einem elektrischen Kabel.

## Claims

1. Method for identifying one or more simultaneously occurring partial discharge sources from partial discharge measurement signals of an electrical device to which an AC voltage is applied, in particular a gas-insulated system, a high-voltage generator, a transformer, an electrical high-voltage power line or an electrical cable, comprising the following steps:
on the basis of a frequency matrix (4) into which measured partial discharge pulses are entered as partial discharge pulse matrix arrays according to the detected pulse amplitude and to the detected phase position and in which partial discharge pulse matrix arrays are allocated to at least one enclosed area of partial discharge pulse matrix arrays,
determining area parameters of the at least one enclosed area of partial discharge pulse matrix arrays;
comparing, for each enclosed area of partial discharge pulse matrix arrays, area parameters of the enclosed area of partial discharge pulse matrix arrays to predetermined rule sets, with each rule set corresponding to a characteristic partial discharge pulse area basic form (34-46); and
allocating, for each enclosed area of partial discharge pulse matrix arrays, that rule set to the enclosed area which best corresponds to the enclosed area, such that one partial discharge pulse area basic form (34-46) is allocated to each enclosed area of partial discharge pulse matrix arrays;
applying predetermined fault rules, which allocate characteristic partial discharge pulse area basic forms (34-46) and characteristic combinations of partial discharge pulse area basic forms (34-46) to known partial discharge sources, to the ascertained partial discharge pulse area basic forms (34-46) in order to determine those partial discharge sources which have rendered the corresponding partial discharge pulses,
**characterized in that**
the partial discharge pulse matrix arrays in the frequency matrix are allocated to at least one enclosed area of partial discharge pulse matrix arrays on the basis of their chain lengths;.
when allocating the partial discharge pulse matrix arrays in the frequency matrix to at least one enclosed area of partial discharge pulse matrix arrays, at first the properties length of contiguous partial discharge pulse matrix arrays in the horizontal direction, length of contiguous partial discharge pulse matrix arrays in the vertical direction, length of contiguous partial discharge pulse matrix arrays in the diagonally ascending direction and length of contiguous partial discharge pulse matrix arrays in the diagonally descending direction are allocated for each partial discharge pulse matrix array; and
when allocating the partial discharge pulse matrix arrays in the frequency matrix to at least one enclosed area of partial discharge pulse matrix arrays, the property length of contiguous partial discharge pulse matrix arrays in the horizontal direction is put into relation with the property length of contiguous partial discharge pulse matrix arrays in the vertical direction for each partial discharge pulse matrix array in order to determine the deduced property cross aspect, and/or wherein, for each partial discharge pulse matrix array, the property length of contiguous partial discharge pulse matrix arrays in the diagonally ascending direction is put into relation with the property length of contiguous partial discharge pulse matrix arrays in the diagonally descending direction in order to determine the deduced property diagonal aspect..

2. Method according to claim 1, wherein a frequency matrix, into which measured partial discharge pulses are entered as partial discharge pulse matrix arrays according to the detected pulse amplitude and to the detected phase position, is first formed, and/or wherein, in the frequency matrix, partial discharge pulse matrix arrays are allocated to at least one enclosed area of partial discharge pulse matrix arrays.

3. Method according to claim 1, wherein, when allocating the partial discharge pulse matrix arrays in the frequency matrix to at least one enclosed area of partial discharge pulse matrix, the properties cross aspect and diagonal aspect are used for adjacent partial discharge pulse matrix arrays in order to determine whether or not adjacent partial discharge pulse matrix arrays belong to the same enclosed area.

4. Method according to claim 1 or 3, wherein, when allocating the partial discharge pulse matrix arrays in the frequency matrix to at least one enclosed area of partial discharge pulse matrix arrays, the deviation of a partial discharge pulse matrix array from the horizontally, vertically and diagonally adjacent partial discharge pulse matrix arrays is determined in pairs for all partial discharge pulse matrix arrays, wherein the deduced properties cross aspect and diagonal aspect are used for this determination of similarity.

5. Method according to claim 3 or 4, wherein, when allocating the partial discharge pulse matrix arrays in the frequency matrix to at least one enclosed area of partial discharge pulse matrix arrays, the cross deviation for each partial discharge pulse matrix array is determined according to the following formula $cross deviation = abs \left(\frac{minimum \left(cross aspect point,cross aspect adjacant point\right)}{maximum \left(cross aspect point,cross aspect adjacant point\right)}-1\right) ,$ wherein abs represents the absolute value, minimum (cross aspect point, cross aspect adjacent point) the minimum of the cross aspect value of the partial discharge pulse matrix array and the cross aspect value of the respectively considered horizontally, vertically and diagonally adjacent partial discharge pulse matrix array, and maximum (cross aspect point, cross aspect adjacent point) the maximum of the cross aspect value of the partial discharge pulse matrix array and the cross aspect value of the respectively considered horizontally, vertically and diagonally adjacent partial discharge pulse matrix array,
the diagonal deviation is determined according to the following formula $diagonal deviation = abs \left(\frac{minimum \left(diagonal aspect point,diagonal aspect adjacant point\right)}{maximum \left(diagonal aspect point,diagonal aspect adjacant point\right)}-1\right) ,$ wherein abs represents the absolute value, minimum (diagonal aspect point, diagonal aspect adjacent point) the minimum of the diagonal aspect value of the partial discharge pulse matrix array and the diagonal aspect value of the respectively considered horizontally, vertically and diagonally adjacent partial discharge pulse matrix array, and maximum (diagonal aspect point, diagonal aspect adjacent point) the maximum of the diagonal aspect value of the partial discharge pulse matrix array and the diagonal aspect value of the respectively considered horizontally, vertically and diagonally adjacent partial discharge pulse matrix array,
and the deviation between cross deviation and diagonal deviation is determined according to the following formula $deviation = max \left(cross deviation, diagonal deviation\right) .$ wherein particularly, when allocating the partial discharge pulse matrix arrays in the frequency matrix to at least one enclosed area of partial discharge pulse matrix arrays, the horizontally, vertically or diagonally adjacent partial discharge pulse matrix array having the greatest still admissible deviation below a predetermined maximum deviation is determined for each partial discharge pulse matrix array; and
wherein particularly the partial discharge pulse matrix arrays in the frequency matrix are allocated to at least one enclosed area of partial discharge pulse matrix arrays by sequentially analyzing, for each partial discharge pulse matrix array, the partial discharge pulse matrix array and the horizontally, vertically or diagonally adjacent partial discharge pulse matrix array having the greatest still admissible deviation below a predetermined maximum deviation; and by, if both partial discharge pulse matrix arrays have not yet been assigned an area number, allocating the partial discharge pulse matrix array to a new area number; if the area number of the adjacent partial discharge pulse matrix array is greater than the area number of the partial discharge pulse matrix array, allocating the area number of the adjacent partial discharge pulse matrix array to the partial discharge pulse matrix array; and, if neither of the two conditions is met, maintaining the area number of the partial discharge pulse matrix array and continuing with the allocation of the next partial discharge pulse matrix array, and
wherein particularly said allocation is repeated for all partial discharge pulse matrix arrays until the area numbers no longer change; and
wherein particularly, when allocating the partial discharge pulse matrix arrays in the frequency matrix to at least one enclosed area of partial discharge pulse matrix arrays, those matrix arrays which are not partial discharge pulse matrix arrays are not considered; and
wherein particularly a partial discharge pulse matrix array is only allocated if the deviation for the considered partial discharge pulse matrix array is below a predetermined maximum deviation value, which ranges between 0.6 and 0.8 and is preferably approx. 0.7; otherwise, the procedure continues with the allocation of the next partial discharge pulse matrix array.

6. Method according to any of the preceding claims, wherein, when allocating the partial discharge pulse matrix arrays in the frequency matrix to at least one enclosed area of partial discharge pulse matrix arrays, all partial discharge pulse matrix arrays the area of which is too small are removed, wherein an area is in particular too small if it comprises less than 10 partial discharge pulse matrix arrays and/or if its horizontal or vertical extension is below 8 partial discharge pulse matrix arrays.

7. Method according to any of the preceding claims, wherein the area parameters of the at least one enclosed area of partial discharge pulse matrix arrays are at least one area parameter from the following group: $area share = number of the partial discharge pulse matrix arrays in the enveloping rectangle / number of all matrix in the enveloping rectange ; aspect ratio of the enveloping rectangle = vertical extenstion / horizontal extension of the enveloping rectangle ; free corners of the enveloping rectangle = corners of the enveloping rectangle at which all matrix arrays are free ; free side centers of the enveloping rectangle = side centers of the$ $enveloping rectangle at which all matrix arrays are free ; curvature to the left ; curvature to the right ; curvature on the top ; curvature on the bottom ; vertical symmetry = symmetry around the vertical center axis ; and horizontal symmetry = symmetry around the horizontal center axis .$

8. Method according to any of the preceding claims, wherein the partial discharge pulse area basic forms (34-46) are at least one of the basic forms from the following group: Spot; Hill; Flame; Tower; Sickle; Fin; Platform.

9. Method according to any of the preceding claims, wherein, in the step of comparing area parameters of the enclosed area of partial discharge pulse matrix arrays to predetermined rule sets for each enclosed area of partial discharge pulse matrix arrays, a probability value is allocated to each enclosed area, said probability value corresponding to the probability of the conformity of the enclosed area with the partial discharge pulse area basic form (34-46) of a characteristic partial discharge source signal, and
wherein particularly the probability of the conformity of the actual value with the target value is calculated by means of a continuous function; and
wherein at least one of the functions $F 1 : = {e}^{- ln \left(tolerance value\right)} {\left(\frac{actual value - target value}{tolerance width}\right)}^{2}$ $F 2 : = 0.5 + arctan \left(normalization∗\left(deviation-actual value\right)\right)$ $F 3 : = 0.5 - arctan \left(normalization∗\left(deviation+actual value\right)\right)$ is used as continuous function, and
wherein the allocation step allocates the rule set having the highest probability value of conformity to the enclosed area.

10. Method according to any of the preceding claims, wherein the fault rules are at least one fault rule from the following group:
fault rule for a test set, fault rule for a detachment, fault rule for a cavity, fault rule for a sliding discharge, fault rule for a particle, fault rule for an apex, fault rule for a free potential, fault rule for a crack, fault rule for a mobile telephone, fault rule for a radar signal, fault rule for amplifier noise, fault rule for an oversized signal, fault rule for a thyristor signal.

11. Method according to any of the preceding claims, wherein the fault rules allocate partial discharge pulse area basic forms (34-46) occurring at particular phase positions to known partial discharge sources and allocate basic forms occurring at particular phase positions and being spaced apart from one another by a particular phase shift to known causative partial discharge sources.

12. Method according to any of the preceding claims, wherein the partial discharge measurement signals of the electrical device to which an AC voltage is applied are detected by means of a partial discharge sensor / partial discharge measuring device.

13. Partial discharge measuring device, which is adapted for detecting partial discharge measurement signals of an electrical device to which an AC voltage is applied, in particular a gas-insulated system, a high-voltage generator, a transformer, an electrical high-voltage power line or an electrical cable, and for carrying out a method for identifying one or more simultaneously occurring partial discharge sources according to any of the preceding claims on the basis of the detected partial discharge measurement signals.

14. Computer program having program instructions for carrying out a method for identifying one or more simultaneously occurring partial discharge sources from partial discharge measurement signals of an electrical device to which an AC voltage is applied, in particular a gas-insulated system, a high-voltage generator, a transformer, an electrical high-voltage power line or an electrical cable, said computer program being adapted for having a method according to any of the preceding claims run on the basis of detected partial discharge measurement signals.

15. Computer system or data carrier with a computer program for carrying out a method according to any of the preceding claims for identifying one or more simultaneously occurring partial discharge sources from partial discharge measurement signals of an electrical device to which an AC voltage is applied, in particular a gas-insulated system, a high-voltage generator, a transformer, an electrical high-voltage power line or an electrical cable.

## Revendications

1. Procédé destiné à la détection d'une ou de plusieurs sources de décharges partielles qui se manifestent de manière simultanée, à partir de signaux de mesure de décharges partielles, d'un dispositif électrique sollicité avec une tension alternative, en particulier d'une installation du type à isolation gazeuse, d'un générateur de haute tension, d'un transformateur, d'une ligne électrique à haute tension ou d'un câble électrique, qui présente les étapes suivantes dans lesquelles :
à partir d'une matrice de fréquence (4), dans laquelle sont introduites des impulsions mesurées de décharges partielles sous la forme de champs matriciels d'impulsions de décharges partielles après avoir enregistré l'amplitude des impulsions et après avoir enregistré les relations de phases, et dans laquelle des champs matriciels d'impulsions de décharges partielles sont associés à au moins une zone fermée de champs matriciels d'impulsions de décharges partielles :
on détermine des partenaires de zone de ladite au moins une zone fermée de champs matriciels d'impulsions de décharges partielles ;
on compare, pour chaque zone fermée de champs matriciels d'impulsions de décharges partielles, des partenaires de zone de la zone fermée de champs matriciels d'impulsions de décharges partielles à des ensembles de règles qui ont été prédéfinies ; dans lequel chaque ensemble de règles correspond à une forme de base caractéristique de la zone d'impulsions de décharges partielles (34 - 46) ; et
on associe, pour chaque zone fermée de champs matriciels d'impulsions de décharges partielles, à la zone fermée l'ensemble de règles qui correspond au mieux à la zone fermée, d'une manière telle qu'une forme de base de la zone d'impulsions de décharges partielles (34 - 46) est associée à chaque zone fermée de champs matriciels d'impulsions de décharges partielles ;
on applique des règles de défauts qui ont été prédéfinies, qui associent des formes de base caractéristiques de la zone d'impulsions de décharges partielles (34 - 46) et des combinaisons caractéristiques de formes de base caractéristiques de la zone d'impulsions de décharges partielles (34 - 46) à des sources connues de décharges partielles aux formes de base de la zone d'impulsions de décharges partielles (34 - 46) qui ont été identifiées, dans le but de déterminer les sources de décharges partielles qui ont émit les impulsions correspondantes de décharges partielles ;
**caractérisé en ce que**
l'on associe les champs matriciels d'impulsions de décharges partielles dans la matrice de fréquence, en se référant à leurs longueurs de chaînes, à au moins une zone fermée de champs matriciels d'impulsions de décharges partielles ;
au cours de l'association des champs matriciels d'impulsions de décharges partielles dans la matrice de fréquence à au moins une zone fermée de champs matriciels d'impulsions de décharges partielles, on associe d'abord, pour chaque champ matriciel d'impulsions de décharges partielles, les propriétés telles que la longueur de champs matriciels d'impulsions de décharges partielles contigus dans la direction horizontale, la longueur de champs matriciels d'impulsions de décharges partielles contigus dans la direction verticale, la longueur de champs matriciels d'impulsions de décharges partielles contigus dans la direction croissante en diagonale et la longueur de champs matriciels d'impulsions de décharges partielles contigus dans la direction décroissante en diagonale, et
au cours de l'association des champs matriciels d'impulsions de décharges partielles dans la matrice de fréquence à au moins une zone fermée de champs matriciels d'impulsions de décharges partielles, pour chaque champ matriciel d'impulsions de décharges partielles, on met en rapport la propriété de longueur de champs matriciels d'impulsions de décharges partielles contigus dans la direction horizontale avec la propriété de longueur de champs matriciels d'impulsions de décharges partielles contigus dans la direction verticale, dans le but de déterminer la propriété de l'aspect croisé qui en découle ; et/ou pour chaque champ matriciel d'impulsions de décharges partielles, on met en rapport la propriété de longueur de champs matriciels d'impulsions de décharges partielles contigus dans la direction croissante en diagonale avec la propriété de longueur de champs matriciels d'impulsions de décharges partielles contigus dans la direction décroissante en diagonale, dans le but de déterminer la propriété de l'aspect diagonal qui en découle.

2. Procédé selon la revendication 1, dans lequel on forme d'abord une matrice de fréquence dans laquelle on introduit des impulsions mesurées de décharge partielle sous la forme de champs matriciels d'impulsions de décharges partielles après avoir enregistré l'amplitude des impulsions et après avoir enregistré les relations de phases ; et/ou dans lequel, dans la matrice de fréquence, on associe des champs matriciels d'impulsions de décharges partielles à au moins une zone fermée de champs matriciels d'impulsions de décharges partielles.

3. Procédé selon la revendication 1, dans lequel, au cours de l'association des champs matriciels d'impulsions de décharges partielles dans la matrice de fréquence à au moins une zone fermée de champs matriciels d'impulsions de décharges partielles, on se réfère aux propriétés d'aspect croisé et d'aspect diagonal pour des champs matriciels d'impulsions de décharges partielles respectivement adjacents dans le but de déterminer le fait de savoir si des champs matriciels d'impulsions de décharges partielles respectivement adjacents font partie de la même zone fermée.

4. Procédé selon la revendication 1 ou 3, dans lequel, au cours de l'association des champs matriciels d'impulsions de décharges partielles dans la matrice de fréquence à au moins une zone fermée de champs matriciels d'impulsions de décharges partielles, pour tous les champs matriciels d'impulsions de décharges partielles, on détermine, par paires, la déviation d'un champ matriciel d'impulsions de décharges partielles par rapport aux champs matriciels d'impulsions de décharges partielles voisins, respectivement en direction horizontale, en direction verticale et en direction diagonale ; dans lequel, pour cette détermination de la ressemblance, on se réfère aux propriétés d'aspect croisé et d'aspect diagonal qui en découlent.

5. Procédé selon la revendication 3 ou 4, dans lequel, au cours de l'association des champs matriciels d'impulsions de décharges partielles dans la matrice de fréquence à au moins une zone fermée de champs matriciels d'impulsions de décharges partielles, pour chaque champ matriciel d'impulsions de décharges partielles, on détermine : la déviation croisée en se référant à la formule indiquée ci-après : $Déviation croisée = abs \left(\frac{minimum \left(point d'aspect croisé, point voisin d'aspect croisé\right)}{maximum \left(point d'aspect croisé, point voisin d'aspect croisé\right)}-1\right)$ dans laquelle « abs » représente la valeur absolue, « minimum (point d'aspect croisé, point voisin d'aspect croisé) » représente la valeur minimum que l'on obtient à partir de la valeur d'aspect croisé du champ matriciel d'impulsions de décharges partielles et de la valeur d'aspect croisé du champ matriciel d'impulsions de décharges partielles voisin que l'on envisage respectivement dans la direction horizontale, dans la direction verticale et dans la direction diagonale, et « maximum (point d'aspect croisé, point voisin d'aspect croisé) » représente la valeur maximum que l'on obtient à partir de la valeur d'aspect croisé du champ matriciel d'impulsions de décharges partielles et de la valeur d'aspect croisé du champ matriciel d'impulsions de décharges partielles voisin que l'on envisage respectivement dans la direction horizontale, dans la direction verticale et dans la direction diagonale ;
la déviation dans la direction diagonale en se référant à la formule indiquée ci-après : $Déviation diagonale = abs \left(\frac{minimum \left(point d'aspect diagonal, point voisin d'aspect diagonal\right)}{maximum \left(point d'aspect diagonal, point voisin d'aspect diagonal\right)}-1\right)$ dans laquelle « abs » représente la valeur absolue, « minimum (point d'aspect diagonal, point voisin d'aspect diagonal) » représente la valeur minimum que l'on obtient à partir de la valeur d'aspect diagonal du champ matriciel d'impulsions de décharges partielles et de la valeur d'aspect diagonal du champ matriciel d'impulsions de décharges partielles voisin que l'on envisage respectivement dans la direction horizontale, dans la direction verticale et dans la direction diagonale, et «maximum (point d'aspect diagonal, point voisin d'aspect diagonal)» représente la valeur maximum que l'on obtient à partir de la valeur d'aspect diagonal du champ matriciel d'impulsions de décharges partielles et de la valeur d'aspect diagonal du champ matriciel d'impulsions de décharges partielles voisin que l'on envisage respectivement dans la direction horizontale, dans la direction verticale et dans la direction diagonale ;
et la déviation entre la déviation croisée et la déviation dans la direction diagonale en se référant à la formule indiquée ci-après : $Déviation = max \left(déviation croisée, déviation diagonale\right)$ et dans lequel, en particulier au cours de l'association des champs matriciels d'impulsions de décharges partielles dans la matrice de fréquence à au moins une zone fermée de champs matriciels d'impulsions de décharges partielles, pour chaque champ matriciel d'impulsions de décharges partielles, on détermine le champ matriciel d'impulsions de décharges partielles voisin dans la direction horizontale, verticale ou diagonale qui présente la déviation la plus élevée encore admise en dessous d'une déviation maximale qui a été prédéfinie ; et dans lequel en particulier le fait d'associer les champs matriciels d'impulsions de décharges partielles dans la matrice de fréquence à au moins une zone fermée de champs matriciels d'impulsions de décharges partielles a lieu d'une manière telle que l'on envisage de manière successive, pour chaque champ matriciel d'impulsions de décharges partielles, le champ matriciel d'impulsions de décharges partielles et le champ matriciel d'impulsions de décharges partielles voisin dans la direction horizontale, verticale ou diagonale qui présentent la déviation la plus élevée en dessous d'une déviation maximale qui a été prédéfinie et on affecte au champ matriciel d'impulsions de décharges partielles un nouveau numéro de zone, lorsque les deux champs matriciels d'impulsions de décharges partielles n'ont pas encore de numéro de zone ; on affecte au champ matriciel d'impulsions de décharges partielles le numéro de zone du champ matriciel voisin d'impulsions de décharges partielles lorsque le numéro de zone du champ matriciel voisin d'impulsions de décharges partielles est supérieur au numéro de zone du champ matriciel d'impulsions de décharges partielles ; et lorsqu'aucune des deux conditions n'est remplie, on conserve le numéro de zone du champ matriciel d'impulsions de décharges partielles, et on poursuit avec l'affectation pour le champ matriciel suivant d'impulsions de décharges partielles ; et dans lequel, en particulier, on applique cette affectation d'une manière itérative à tous les champs matriciels d'impulsions de décharges partielles jusqu'à ce que l'on n'obtienne plus aucune modification de numéros de zone ; et dans lequel, en particulier au cours de l'affectation des champs matriciels d'impulsions de décharges partielles dans la matrice de fréquence à au moins une zone fermée de champs matriciels d'impulsions de décharges partielles, on ne prend pas en compte les champs matriciels qui ne représentent pas des champs matriciels d'impulsions de décharges partielles ; et dans lequel, en particulier, on ne procède à l'affectation pour un champ matriciel d'impulsions de décharges partielles que lorsque la déviation pour le champ matriciel d'impulsions de décharges partielles respectivement pris en compte est inférieure à une valeur de déviation maximale qui a été prédéfinie, qui se situe dans une plage de 0,6 à 0,8 et qui s'élève de préférence à environ 0,7 ; et dans le cas contraire on poursuit l'affectation pour le champ matriciel d'impulsions de décharges partielles suivant.

6. Procédé selon l'une quelconque des revendications précédentes, dans lequel, au cours de l'association des champs matriciels d'impulsions de décharges partielles dans la matrice de fréquence à au moins une zone fermée de champs matriciels d'impulsions de décharges partielles, on élimine tous les champs matriciels d'impulsions de décharges partielles dont la zone est trop petite ; dans lequel une zone est considérée en particulier comme étant trop petite lorsqu'elle comprend moins de 10 champs matriciels d'impulsions de décharges partielles et/ou lorsque son étendue dans la direction horizontale ou verticale est inférieure à 8 champs matriciels d'impulsions de décharges partielles.

7. Procédé selon l'une quelconque des revendications précédentes, dans lequel, en ce qui concerne les partenaires de zone de ladite au moins une zone fermée de champs matriciels d'impulsions de décharges partielles, il s'agit d'au moins un partenaire de zone qui est choisi à partir du groupe indiqué ci-après : taux de recouvrement = nombre des champs matriciels d'impulsions de décharges partielles dans le rectangle à recouvrir / nombre de tous les champs matriciels dans le rectangle à recouvrir; rapport nominal d'aspect du rectangle à recouvrir = étendue dans la direction verticale / étendue dans la direction horizontale du rectangle à recouvrir ; coins libres du rectangle à recouvrir = coins du rectangle à recouvrir auxquels tous les champs matriciels sont vacants ; milieux des côtés libres du rectangle à recouvrir = milieu des côtés du rectangle à recouvrir auxquels tous les champs matriciels sont vacants ; courbure vers la gauche ; courbure vers la droite ; courbure en haut ; courbure en bas ; symétrie verticale = symétrie autour de l'axe médian vertical ; et symétrie horizontale = symétrie autour de l'axe médian horizontal.

8. Procédé selon l'une quelconque des revendications précédentes, dans lequel, en ce qui concerne les formes de base de la zone d'impulsions de décharges partielles (34 - 46), il s'agit d'au moins une des formes de base choisie parmi le groupe suivant : point ; crête ; flamme ; tour ; croissant ; nageoire ; plan.

9. Procédé selon l'une quelconque des revendications précédentes, dans lequel, dans l'étape de la comparaison, pour chaque zone fermée de champs matriciels d'impulsions de décharges partielles, parmi les partenaires de zone de la zone fermée des champs matriciels d'impulsions de décharges partielles possédant des ensembles de règles qui ont été prédéfinies, on attribue, à chaque zone fermée, une valeur de vraisemblance qui correspond à la vraisemblance de la coïncidence de la zone fermée avec la forme de base de la zone d'impulsions de décharges partielles (34 - 46) d'un signal caractéristique de source de décharges partielles ; et dans lequel, en particulier, on calcule la vraisemblance de la coïncidence de la valeur réelle (IST) avec la valeur de consigne (SOLL) par l'intermédiaire d'une fonction continue ; et dans lequel, en particulier, on utilise à titre de fonction continue au moins une des fonctions indiquées ci-après : $F 1 : = {e}^{- ln \left(valeur de tolérance\right) {\left(\frac{valeur réelle - valeur de consigne}{marge de tolérance}\right)}^{2}}$ $F 2 : = 0,5 + arctan \left(normalisation∗\left(décalage-valeur réelle\right)\right)$ $F 3 : = 0,5 - arctan \left(normalisation∗\left(décalage+valeur réelle\right)\right)$ et dans lequel, dans l'étape d'attribution, on attribue à la zone fermée, l'ensemble de règles qui présentent la valeur de vraisemblance de coïncidence la plus élevée.

10. Procédé selon l'une quelconque des revendications précédentes, dans lequel, en ce qui concerne les règles de défauts, il s'agit d'au moins une règle de défaut qui est choisie parmi le groupe indiqué ci-après : des règles de défauts pour un ensemble test, des règles de défauts pour un décollement, des règles de défauts pour un creux, des règles de défauts pour une décharge glissante, des règles de défauts pour une particule, des règles de défauts pour une pointe, des règles de défauts pour un potentiel libre, des règles de défauts pour une fissure, des règles de défauts pour un téléphone mobile, des règles de défauts pour un signal de radar, des règles de défauts pour un souffle d'amplificateur, des règles de défauts pour un trop grand signal d'entrée, des règles de défauts pour un signal de thyristor.

11. Procédé selon l'une quelconque des revendications précédentes, dans lequel on associe les règles de défauts à des sources de décharges partielles connues dans le cas de formes de base de la zone d'impulsions de décharges partielles (34 - 46) qui se manifestent avec des relations de phases déterminées, et on les associe, dans le cas de formes de base espacées les unes des autres à concurrence d'un décalage de phase déterminé, qui se manifestent avec des relations de phases déterminées, à des sources de décharges partielles causales connues.

12. Procédé selon l'une quelconque des revendications précédentes, les signaux de mesure de décharges partielles du dispositif électrique sollicité avec une tension alternative sont enregistrés avec un capteur de décharges partielles / un appareil de mesure de décharges partielles.

13. Appareil de mesure de décharges partielles qui est réalisé à des fins d'enregistrement de signaux de mesure de décharges partielles d'un dispositif électrique sollicité avec une tension alternative, en particulier d'une installation du type à isolation gazeuse, d'un générateur de haute tension, d'un transformateur, d'une ligne électrique à haute tension ou d'un câble électrique, et qui est conçu pour mettre en œuvre un procédé destiné à la détection d'une ou de plusieurs sources de décharges partielles qui se manifestent de manière simultanée selon l'une quelconque des revendications précédentes, en se basant sur les signaux de mesure de décharges partielles enregistrés.

14. Programme informatique comprenant des instructions de programme pour la mise en œuvre d'un procédé destiné à la détection d'une ou de plusieurs sources de décharges partielles qui se manifestent de manière simultanée à partir de signaux de mesure de décharges partielles, d'un dispositif électrique sollicité avec une tension alternative, en particulier d'une installation du type à isolation gazeuse, d'un générateur de haute tension, d'un transformateur, d'une ligne électrique à haute tension ou d'un câble électrique, qui est réalisé d'une manière telle qu'un procédé selon l'une quelconque des revendications précédentes peut être mise en oeuvre en se basant sur des signaux de mesure de décharges partielles enregistrés.

15. Système informatique ou support de données comprenant un programme informatique pour la mise en oeuvre d'un procédé selon l'une quelconque des revendications précédentes qui est destiné à la détection d'une ou de plusieurs sources de décharges partielles qui se manifestent de manière simultanée à partir de signaux de mesure de décharges partielles, d'un dispositif électrique sollicité avec une tension alternative, en particulier d'une installation du type à isolation gazeuse, d'un générateur de haute tension, d'un transformateur, d'une ligne électrique à haute tension ou d'un câble électrique.
